# EUROPEAN PATENT APPLICATION

(11) **EP 4 741 407 A1**
(43) Date of publication of application: **13.05.2026**
(21) Application number: 23945688.2
(22) Date of filing: 04.12.2023
(51) Int. Cl.: C07F 15/00, C09K 11/06, H10K 85/30, H10K 50/11

(54) **PYRIDINOCARBENE-BASED TETRADENTATE CYCLOMETALATED PLATINUM (II) COMPLEX AND USE THEREOF**

(30) Priority: 18.07.2023 CN 202310879484
(71) Applicant: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); TONG, Jieying, Hangzhou, Zhejiang 310014 (CN); ZHAN, Feng, Hangzhou, Zhejiang 310014 (CN); CHEN, Jianqiang, Hangzhou, Zhejiang 310014 (CN); SHE, Yuanbin, Hangzhou, Zhejiang 310014 (CN); WU, Kongwu, Jiaxing, Zhejiang 314107 (CN)
(74) Representative: Chung, Hoi Kan
(86) International application number: PCT/CN2023/136010
(87) International publication number: WO 2025/015809

(57) **Abstract**

A pyridine-fused carbene-based tetradentate cyclometalated platinum(II) complex is provided. Compared to a benzo-fused carbene-based platinum(II) complex, since a pyridine-fused carbene exhibits stronger an electron-withdrawing capacity, an excited state of a pyridine-fused carbene-based tetradentate cyclometalated platinum(II) complex is endowed with a greater proportion of metal-to-pyridine-fused carbene charge transfer states (³MLCT). This facilitates an increase in radiative rate, thereby enhancing lifetime of a device. Materials provided in the present disclosure all exhibit excellent chemical and thermal stability, facilitating the fabrication of vacuum-evaporated OLED devices. Organic electroluminescent devices fabricated with compounds of the present disclosure as light-emitting layers demonstrate significant improvements in both current efficiency and lifetime, while also markedly reducing a turn-on voltage. Combining the compounds of the present disclosure with fluorescent dopant materials (boron-containing compounds) can balance transport of holes and electrons, enable more efficient energy transfer between host and guest materials, and enhance light color purity of devices.

## Description

### TECHNICAL FIELD

The present disclosure relates to the field of organic electroluminescence, specifically to a pyridine-fused carbene-based tetradentate cyclometalated platinum(II) complex and an application thereof.

### BACKGROUND

Organic light-emitting diodes (OLEDs) represent a new generation of full-color display and lighting technology. As self-luminous devices, OLEDs offer advantages such as no requirement for backlight, low drive voltage, quick response, high resolution and contrast, wide viewing angle and excellent low-temperature performance; and OLED devices may be fabricated to be thin and into flexible structures. In additional, OLEDs further offer advantages such as low production costs, a simple manufacturing process and suitability for large-format products. The core of the development of OLEDs lies in design and development of light-emitting materials. Red OLEDs and green OLEDs have essentially reached the standards for commercial application. However, due to long lifetime of triplet excitons and wide bandgaps of blue light-emitting materials, blue OLED devices are prone to triplet exciton accumulation and cleavage of organic molecular chemical bonds at high brightness levels. This severely compromises the stability of the devices, thereby significantly limiting the development and application of blue OLEDs.

Research on organic blue light-emitting materials of OLEDs, both domestically and internationally, is developing along multiple pathways. Currently, light-emitting layers of OLED devices almost exclusively employs a host-guest light-emitting system, i.e., doping a host material with a guest light-emitting material. An energy gap of the host material is typically higher than that of the guest light-emitting material, such that energy is transferred from the host material to the guest light-emitting material, thereby leading to excitation and subsequent light emission of the guest light-emitting material. Common organic phosphorescent guest materials are predominantly complexes of heavy metals such as iridium(III), platinum(II) and palladium(II). Currently, heavy-metal phosphorescent organic complexes in use are mainly cyclometalated iridium(III) complex molecules, whose variety is limited. In contrast, preparation of platinum(II) complex phosphorescent materials exhibits high platinum utilization, which may further reduce preparation costs of the platinum(II) complex phosphorescent materials. The preparation costs of the platinum(II) complex phosphorescent materials are significantly lower than those of iridium(III) complex phosphorescent materials. However, there are still some technical challenges in the development of platinum complex materials and devices, and improving device efficiency and lifetime remains an important research topic. Therefore, novel phosphorescent platinum(II) metal complexes need to be developed.

### SUMMARY

In view of the above, the present disclosure aims to provide a pyridine-fused carbene-based tetradentate cyclometalated platinum(II) complex and an application thereof. An organic electroluminescent device fabricated by using the pyridine-fused carbene-based tetradentate cyclometalated platinum(II) complex of the present disclosure as a light-emitting layer may be enabled to exhibit excellent performance, current efficiency of the organic electroluminescent device may be enhanced, lifetime of the device may be improved, and an operating voltage of the device may also be reduced.

To achieve the above-described technical objectives, the technical solutions of the present disclosure are as described below.

The present disclosure provides a pyridine-fused carbene-based tetradentate cyclometalated platinum(II) complex. A structure of the pyridine-fused carbene-based tetradentate cyclometalated platinum(II) complex is as shown in formula (I):

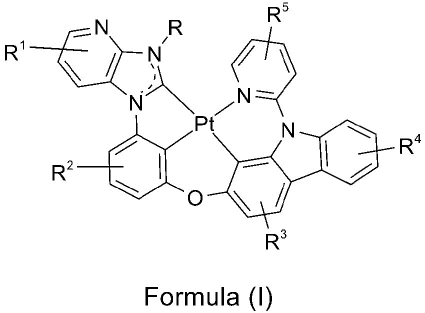

In formula (I), R¹-R⁵ each independently represent from mono to maximum allowable substitution, or no substitution; R¹-R⁵ are each independently selected from the group consisting of: hydrogen, deuterium (D), C1-C30 alkyl, C1-C30 deuterated alkyl, C6-C60 aryl, C6-C30 aryl silane, and combinations thereof; R is selected from the group consisting of hydrogen, deuterium, C1-C30 alkyl, C1-C30 cycloalkyl, C1-C30 deuterated alkyl, C6-C60 aryl, C6-C30 fused-ring aryl, and combinations thereof.

Furthermore, R¹-R⁵ are each independently selected from hydrogen, deuterium, methyl, ethyl, n-propyl, isopropyl, n-butyl, isobutyl, sec-butyl, tert-butyl, n-pentyl, isopentyl, sec-pentyl, tert-pentyl, n-hexyl, isohexyl, sec-hexyl, tert-hexyl, n-heptyl, isoheptyl, sec-heptyl, tert-heptyl, n-octyl, iso-octyl, sec-octyl, tert-octyl, n-nonyl, iso-nonyl, sec-nonyl, tert-nonyl, n-decyl, isodecyl, sec-decyl, tert-decyl, phenyl, triphenylsilane, and combinations thereof.

Furthermore, R is selected from amantadine, tert-butyl, tert-butylphenyl, and groups represented by following structural formulas:

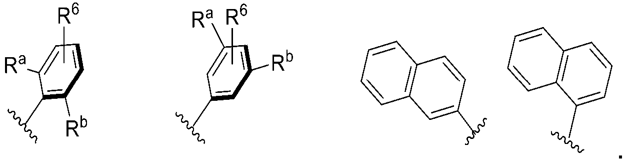

R⁶ represents from mono to maximum substitution, or no substitution. R⁶ is selected from hydrogen, C1-C20 alkyl and C1-C20 deuterated alkyl.

R^{a} and R^{b} are identically or independently selected from C3-C30 alkyl, C1-C20 deuterated alkyl, C5-C30 cycloalkyl, C6-C30 aryl, and combinations thereof.

Furthermore, R⁶ is selected from hydrogen, methyl, n-propyl, isopropyl, n-butyl, isobutyl, sec-butyl, tert-butyl, D and CD₃; R^{a} and R^{b} are identically or independently selected from methyl, ethyl, n-propyl, isopropyl, n-butyl, isobutyl, sec-butyl, tert-butyl, n-pentyl, isopentyl, sec-pentyl, tert-pentyl, n-hexyl, iso-hexyl, sec-hexyl, tert-hexyl and phenyl.

Furthermore, the pyridine-fused carbene-based tetradentate cyclometalated platinum(II) complex is any one selected from chemical structures shown below. Here, D represents deuterium, and Ph represents phenyl.

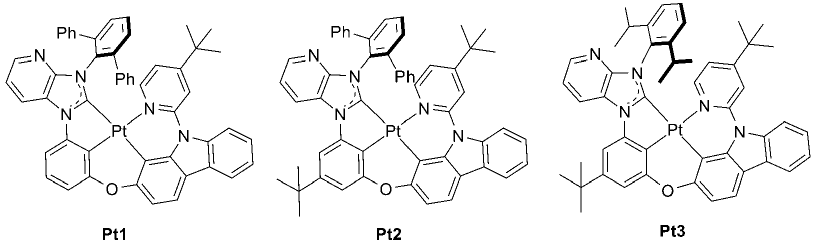

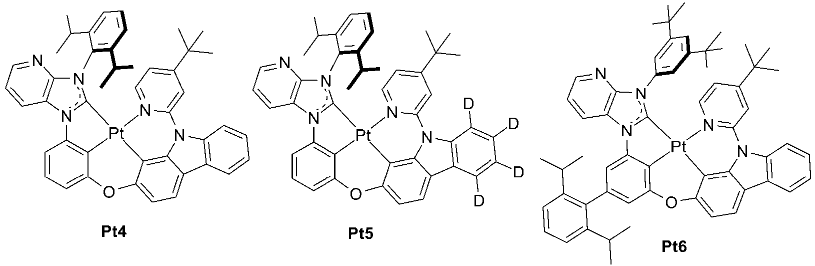

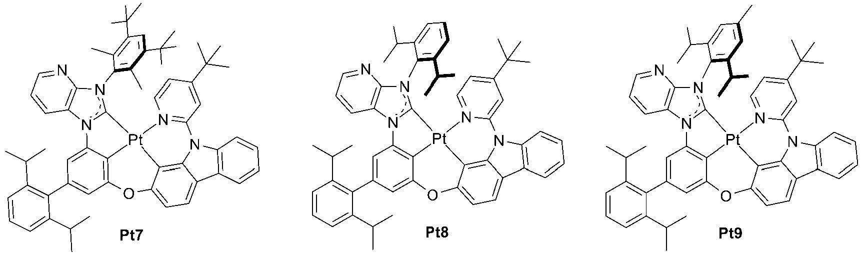

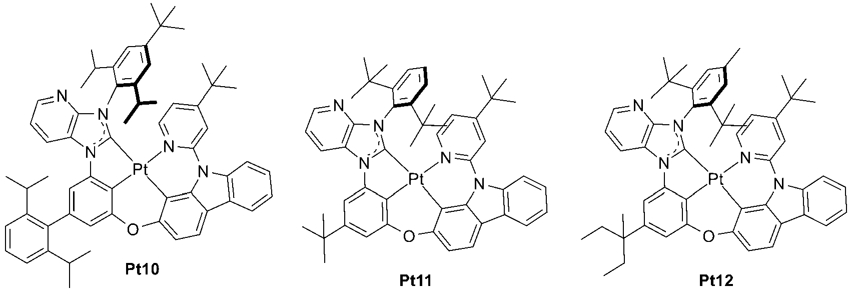

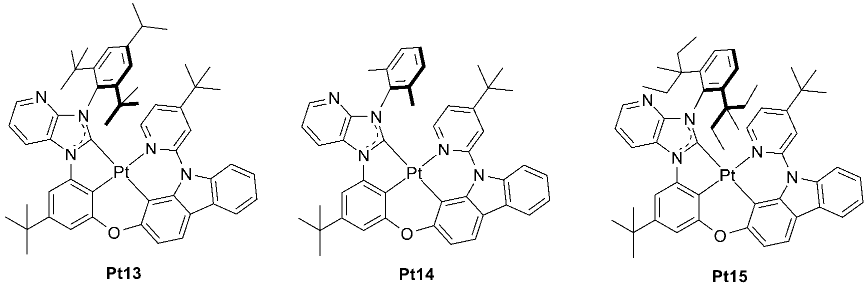

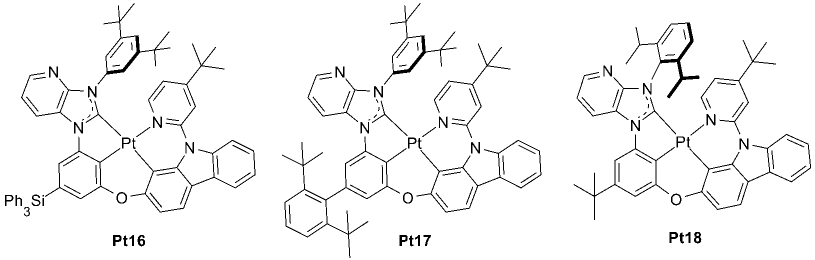

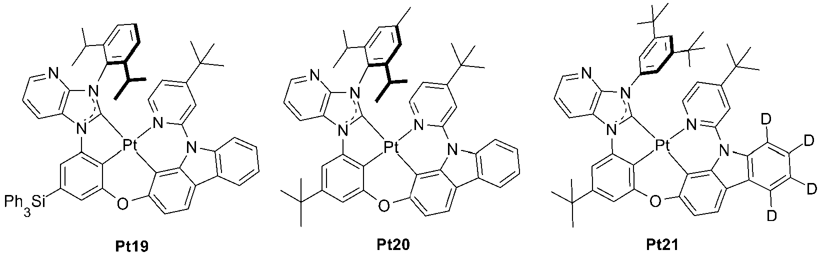

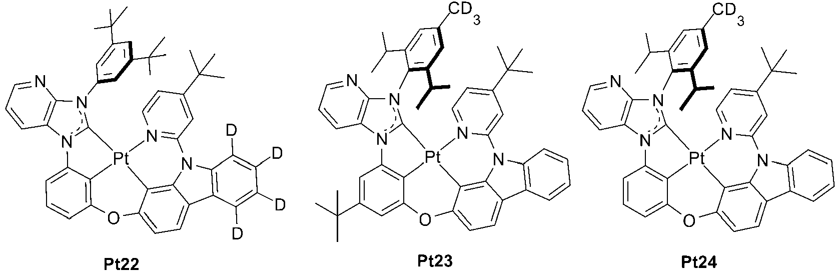

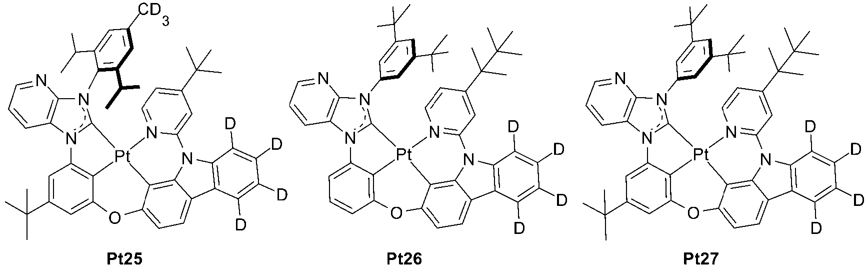

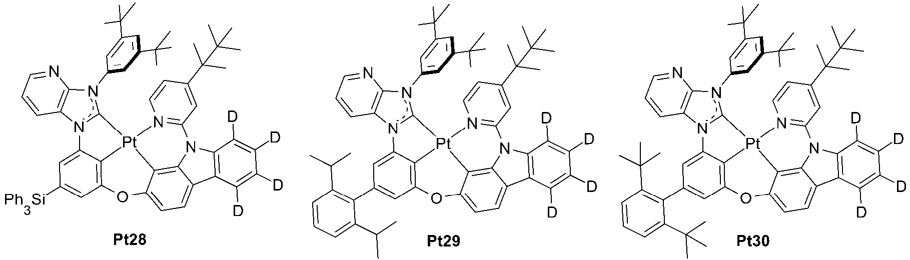

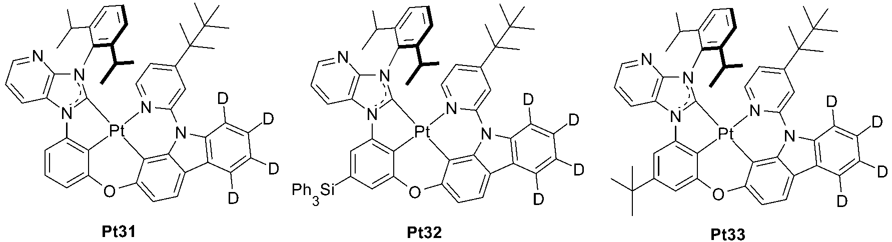

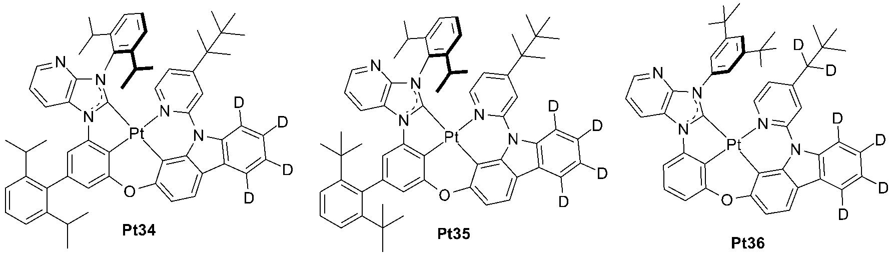

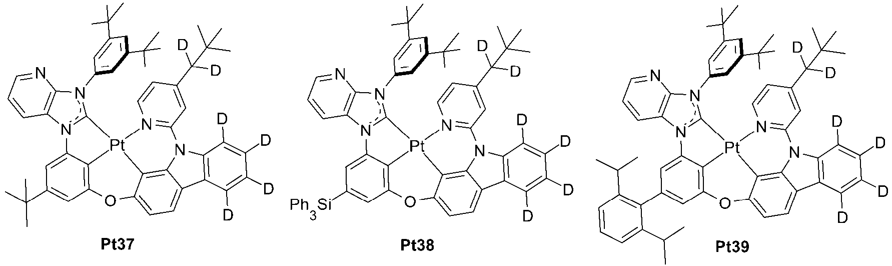

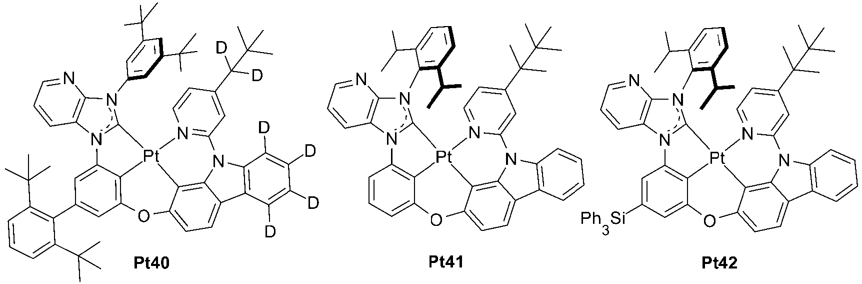

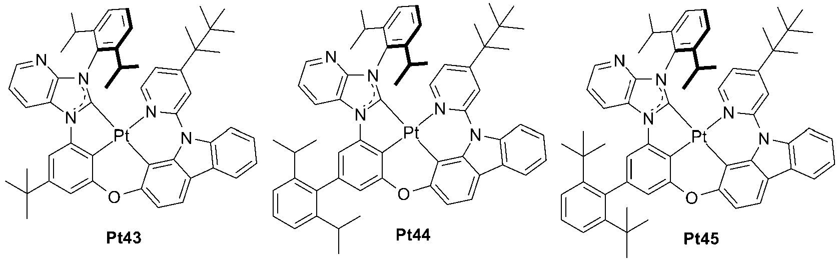

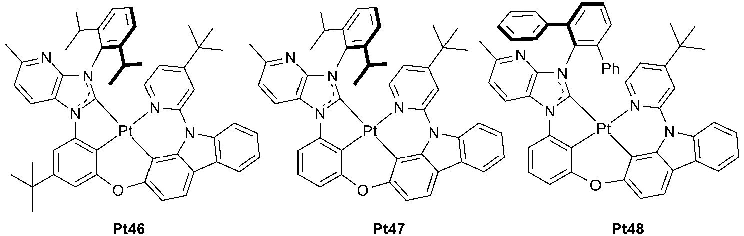

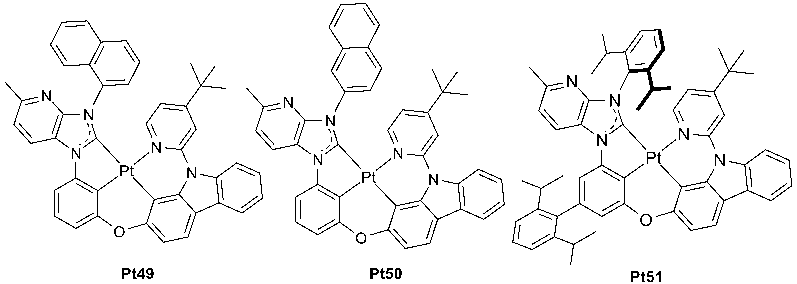

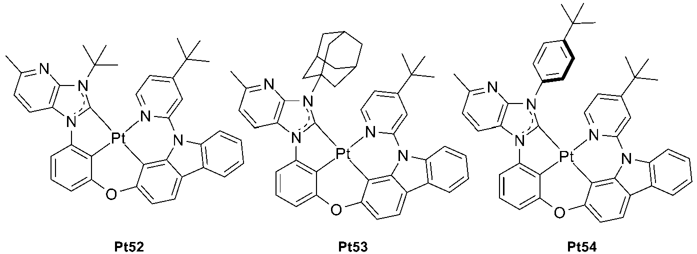

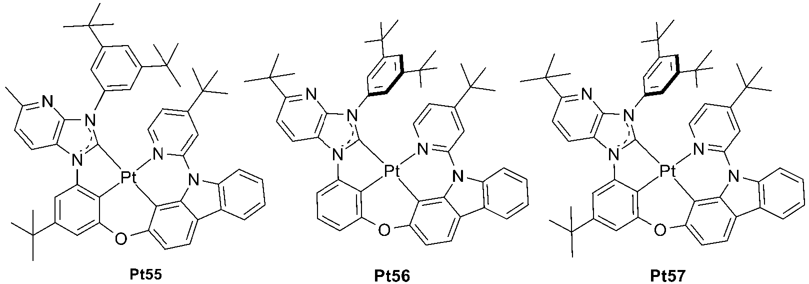

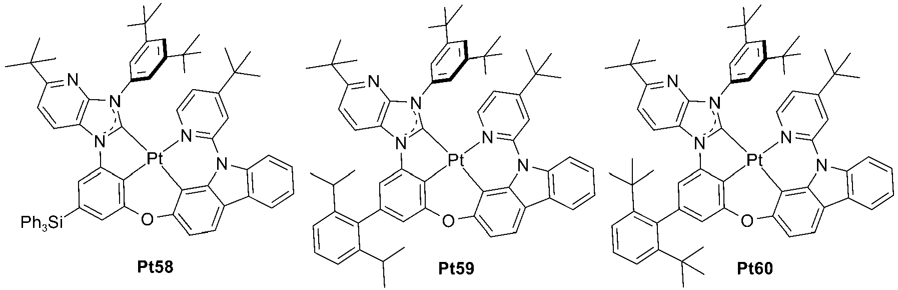

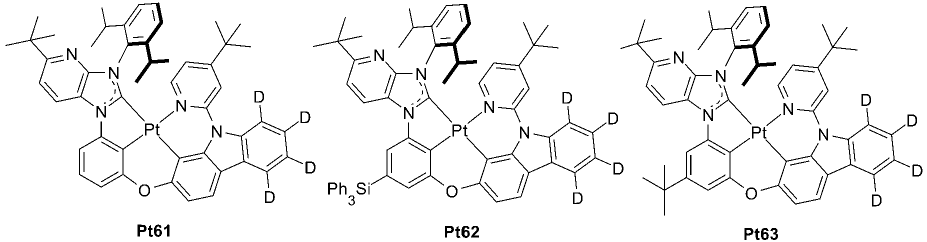

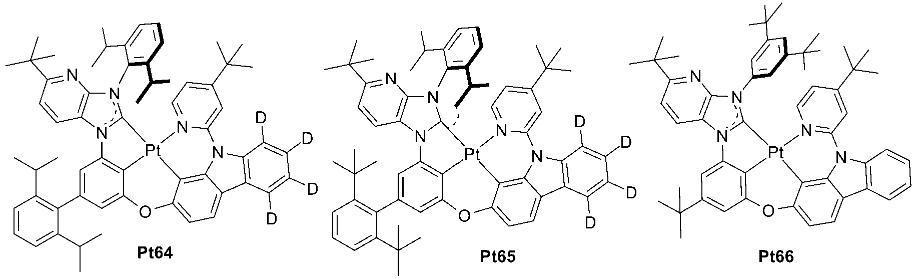

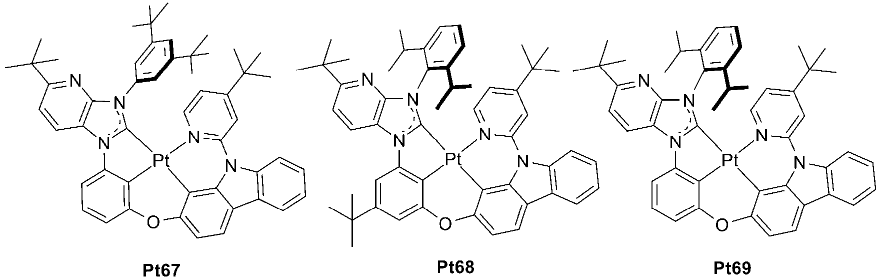

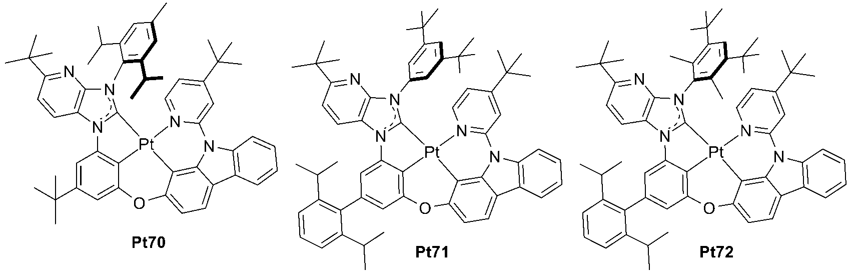

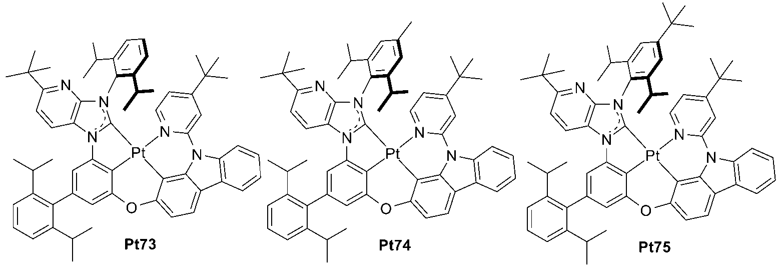

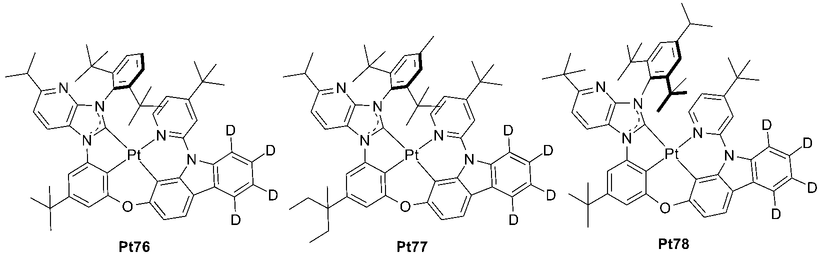

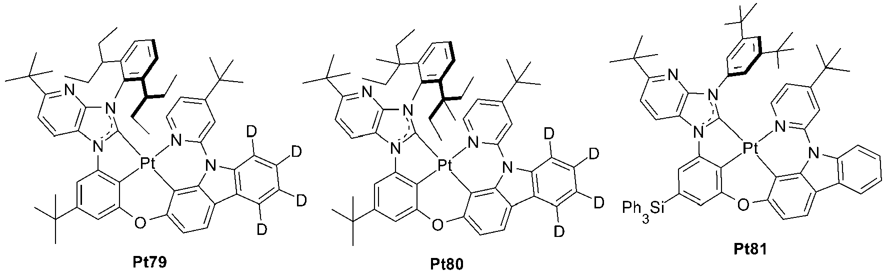

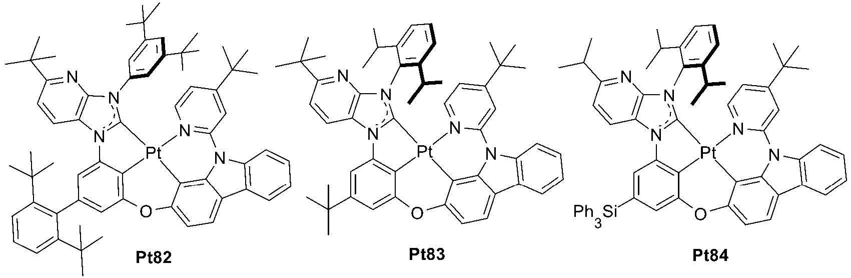

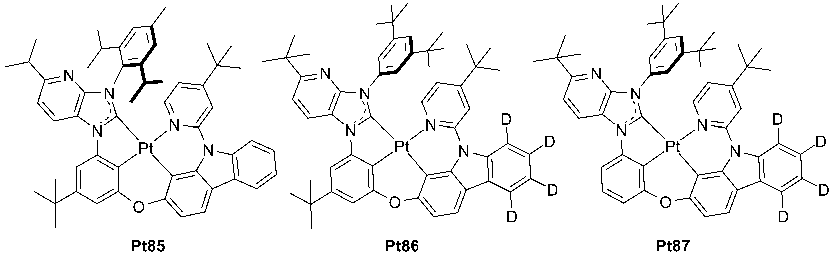

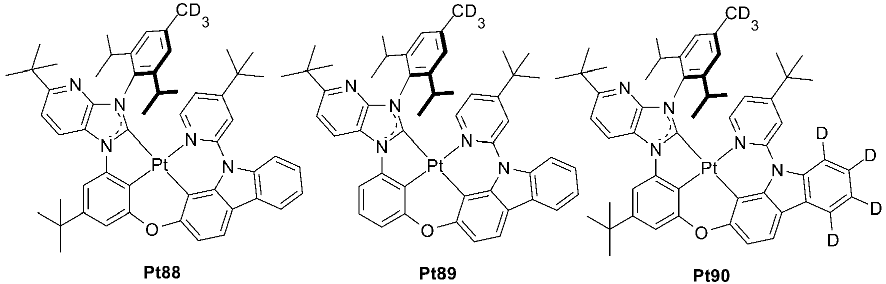

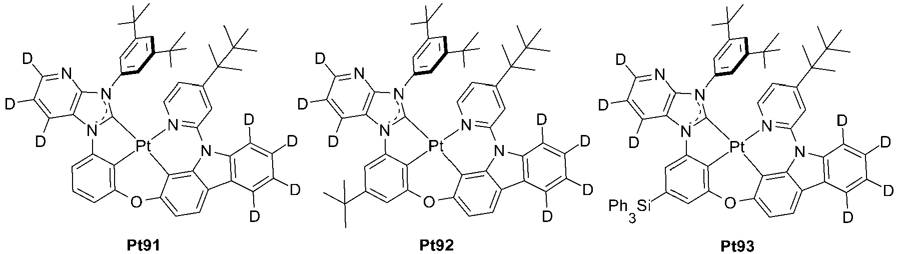

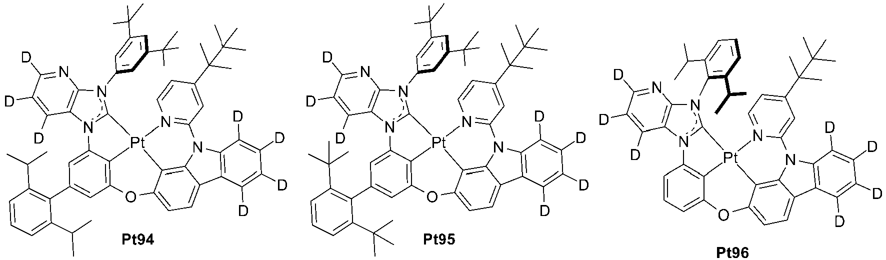

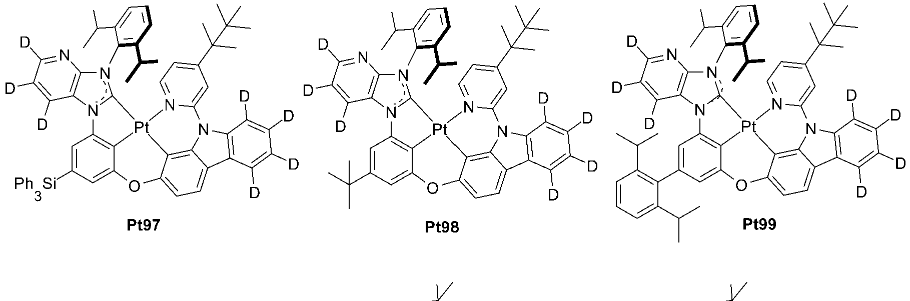

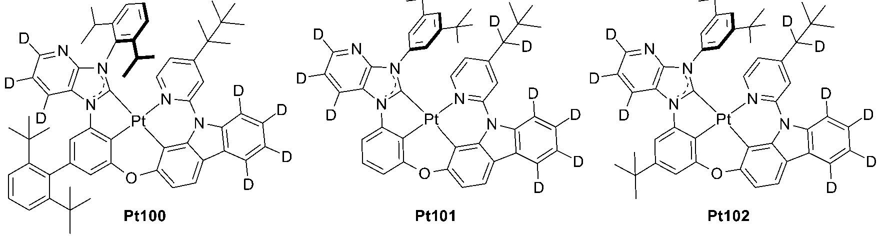

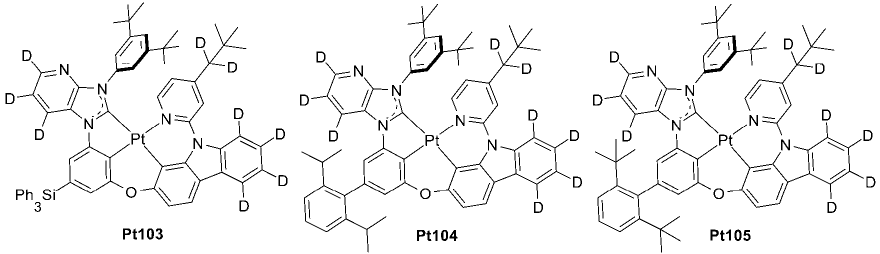

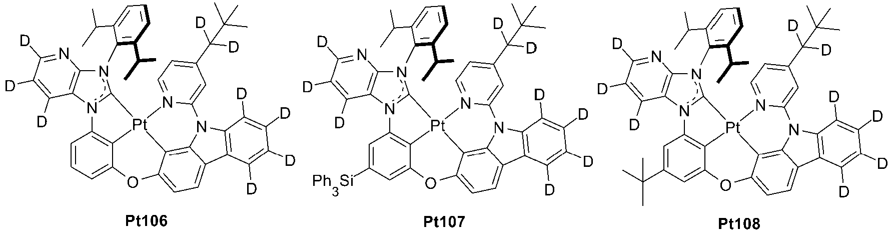

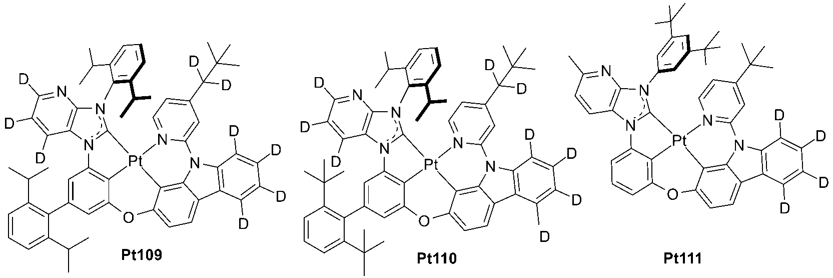

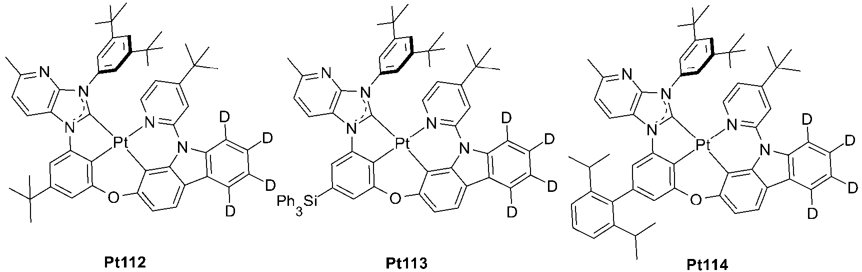

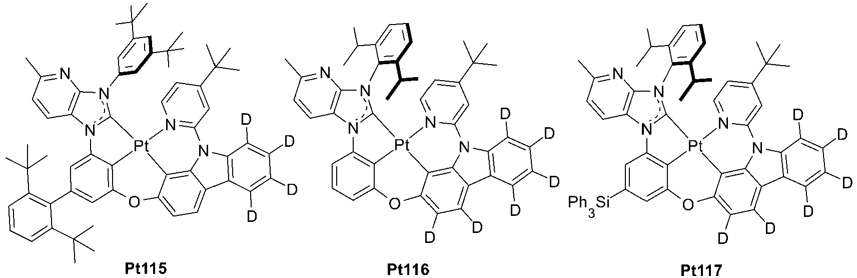

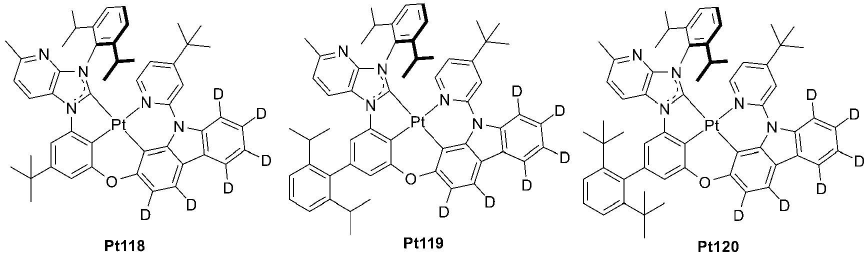

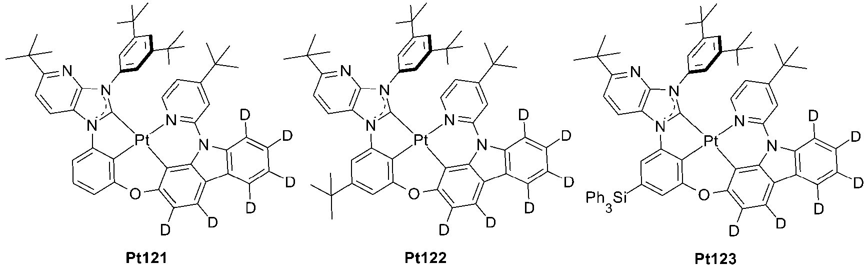

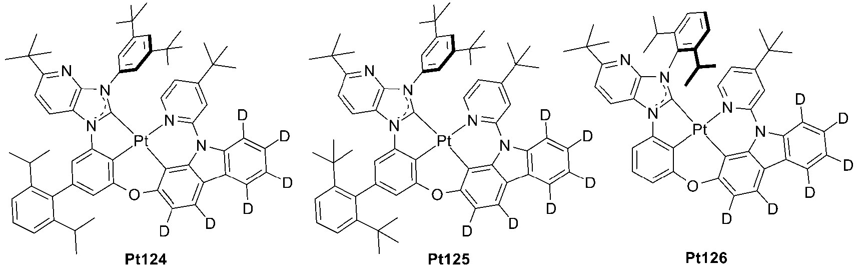

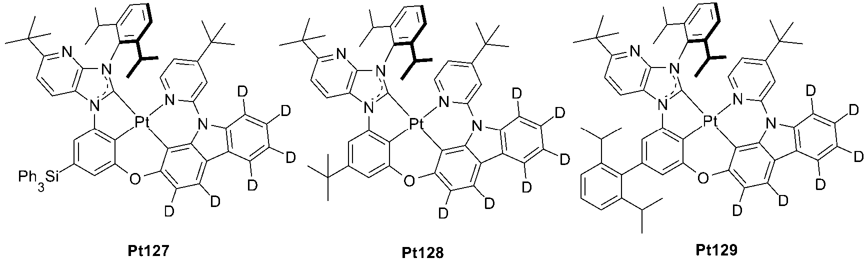

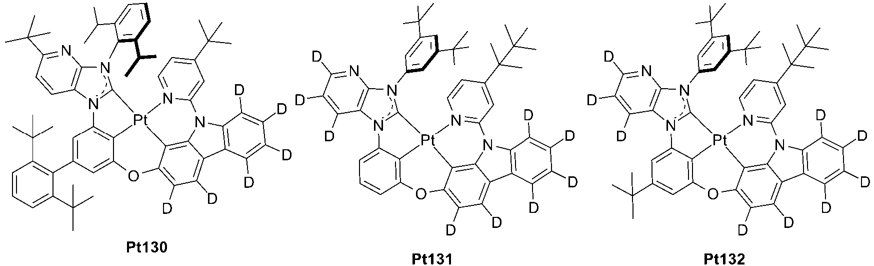

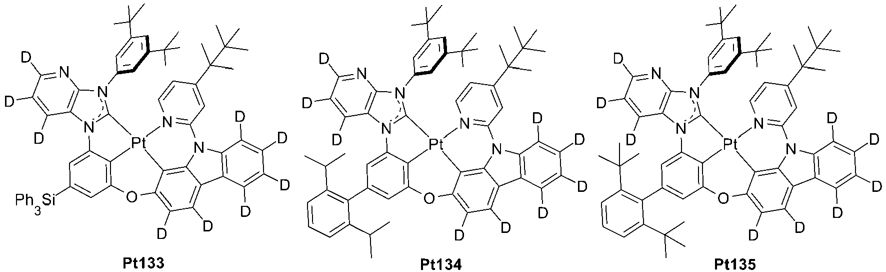

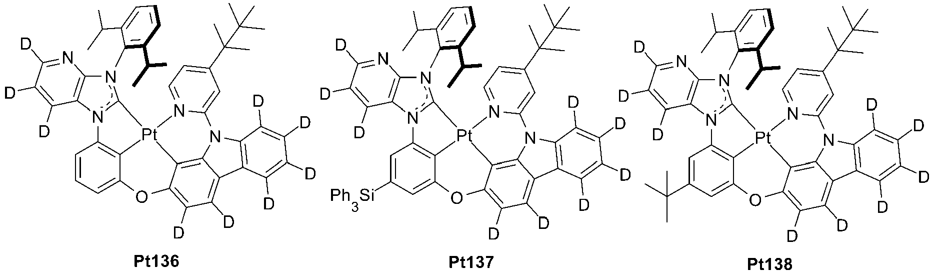

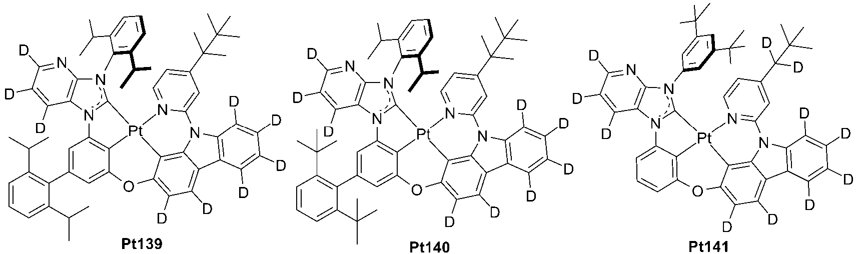

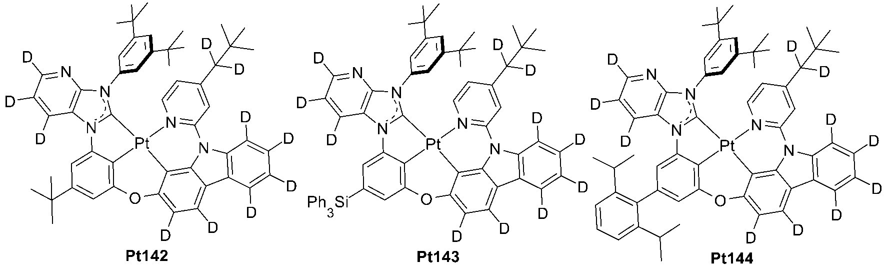

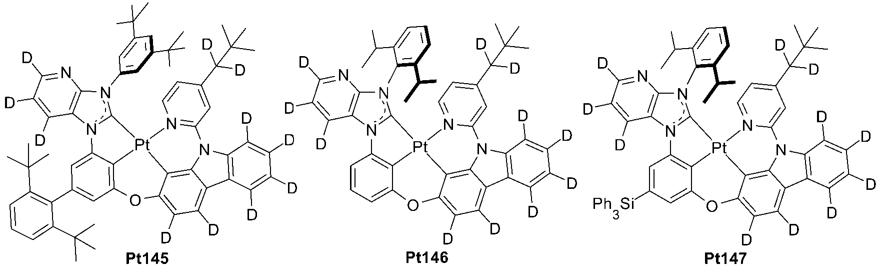

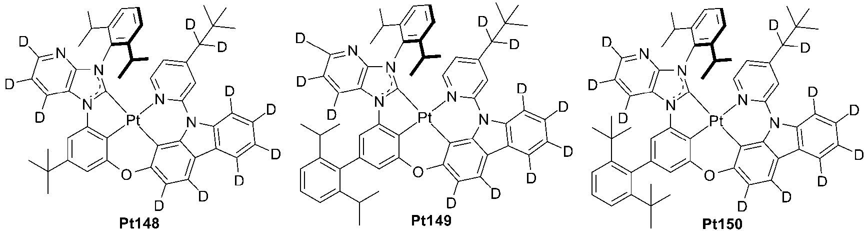

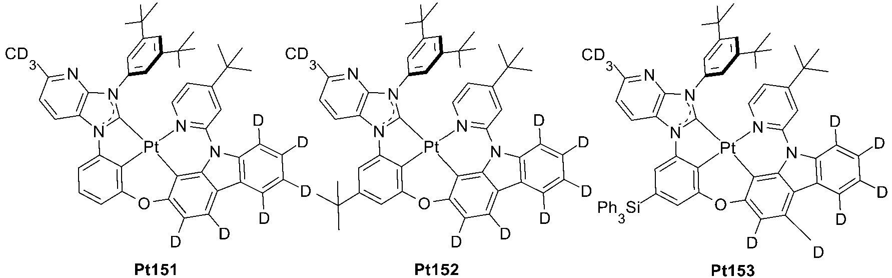

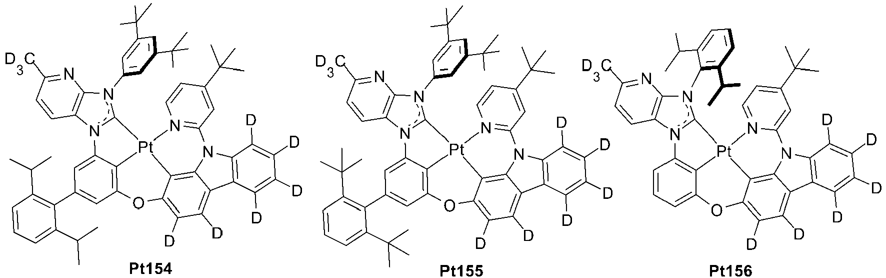

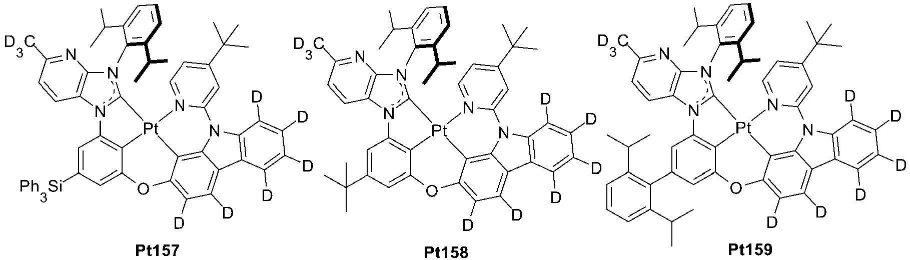

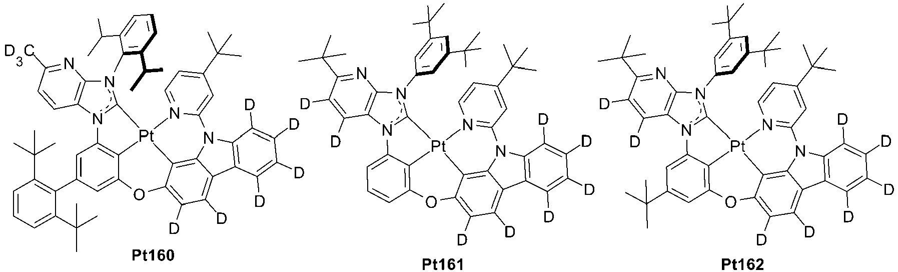

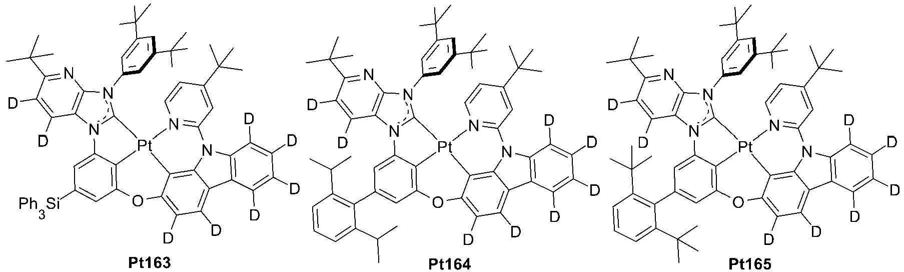

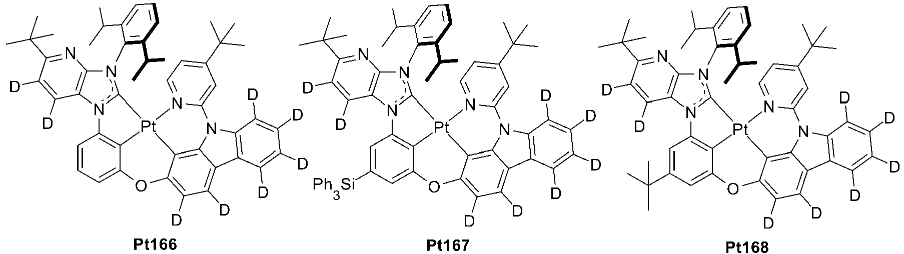

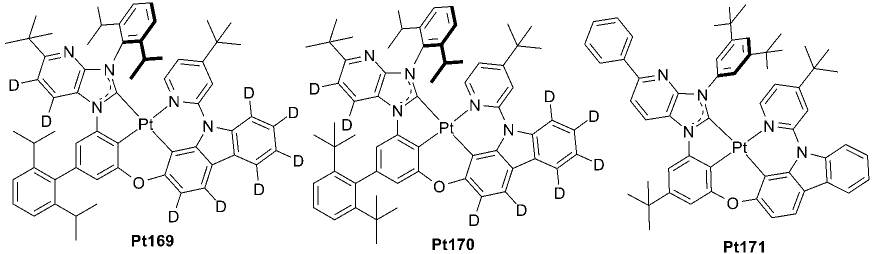

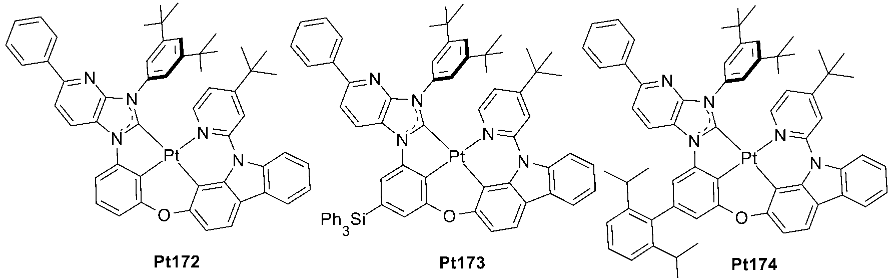

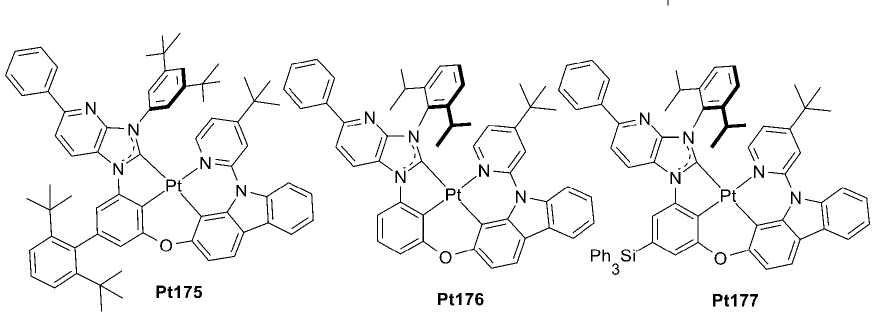

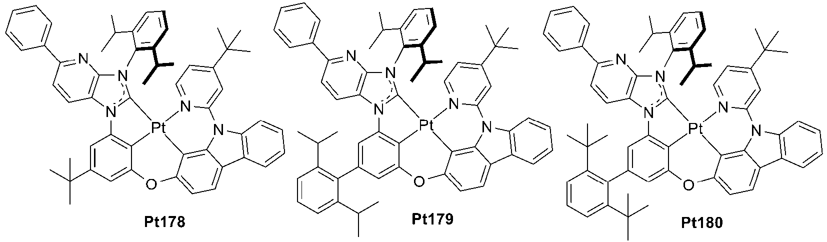

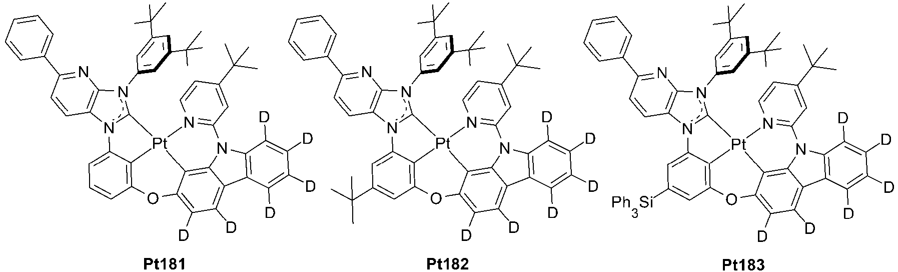

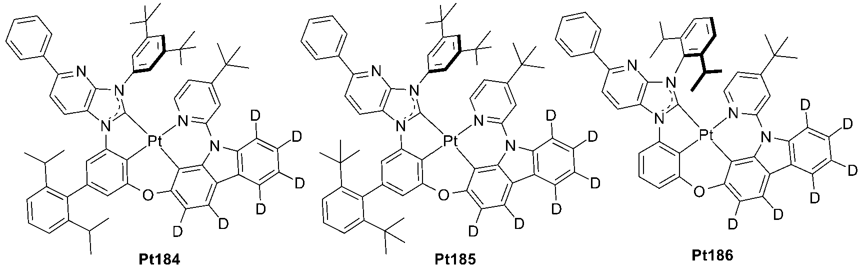

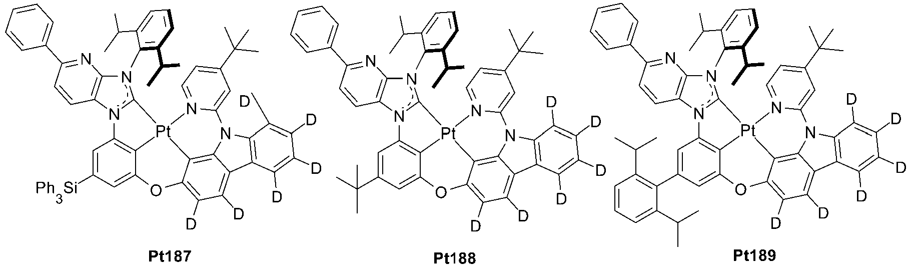

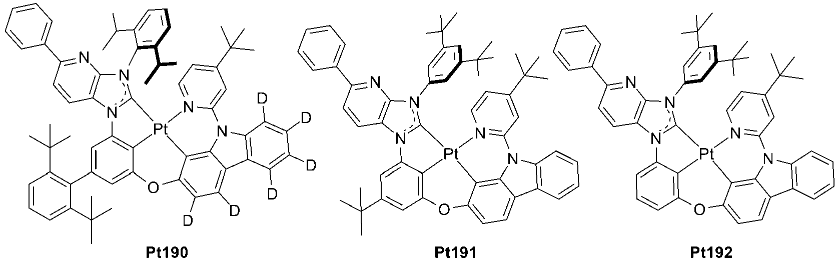

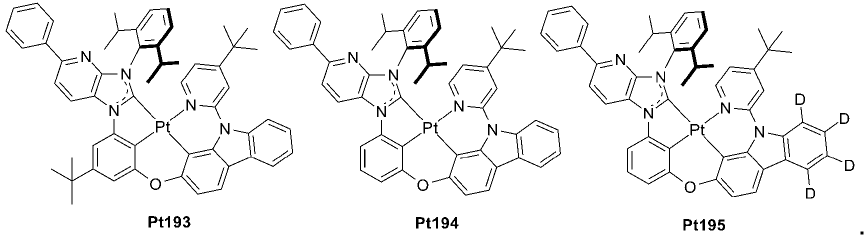

Furthermore, the present disclosure further provides an application of the tetradentate cyclometalated platinum(II) complex having the structure of formula (I) in an electronic device.

Furthermore, the electronic device includes one or more of an organic electroluminescent device (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organophotoreceptor, an organic field-quench device (O-FQD), a light-emitting electrochemical cell (LEC) and an organic laser diode (O-laser).

In another aspect, the present disclosure further provides an organic electroluminescent device. The organic electroluminescent device includes the tetradentate cyclometalated platinum(II) complex having the structure as shown in formula (I).

Furthermore, the organic electroluminescent device includes a cathode, an anode and an organic functional layer between the cathode and the anode. The organic functional layer contains the tetradentate cyclometalated platinum(II) complex having the structure as shown in formula (I).

Preferably, the organic functional layer includes a light-emitting layer. The light-emitting layer contains the tetradentate cyclometalated platinum(II) complex having the structure as shown in formula (I).

Furthermore, the light-emitting layer further includes a fluorescent dopant material. The fluorescent dopant material is preferably a boron-containing organic molecular light-emitting material.

In still another aspect, the present disclosure further provides an organic optoelectronic device. The organic optoelectronic device includes: a substrate layer, a first electrode disposed on the substrate; an organic light-emitting functional layer disposed on the first electrode, and a second electrode disposed on the organic light-emitting functional layer. The organic light-emitting functional layer contains the tetradentate cyclometalated platinum(II) complex having the structure as shown in formula (I). For example, the platinum(II) complex may be contained as a light-emitting material in the organic light-emitting functional layer.

Furthermore, the organic light-emitting functional layer further includes any one or more fluorescent dopant materials. The fluorescent dopant materials are preferably boron-containing organic molecular light-emitting materials.

In the present disclosure, the organic optoelectronic device may fabricated as follows: forming an anode on a substrate by depositing a metal, an conductive oxide, or an alloy thereof by means of a method such as sputter coating, electron beam evaporation, or vacuum evaporation; sequentially depositing a hole injection layer, a hole transport layer, a light-emitting layer, a hole blocking layer and an electron transport layer on a surface of the formed anode; then, depositing a cathode. In addition to the above method, the organic electroluminescent device may also be fabricated by sequentially depositing a cathode, an organic layer and an anode on a substrate. The organic layer may also include a plurality of layers of structures such as a hole injection layer, a hole transport layer, a light-emitting layer, a hole blocking layer and an electron transport layer. In the present disclosure, the organic layer is formed by using a polymer material via a solution-processing method (e.g., spin-coating, tape-casting, doctor-blading, screenprinting, inkjet printing or thermal imaging) instead of vapor evaporation, which may reduce the number of layers of a device.

The present disclosure further provides a composition. The composition contains the tetradentate cyclometalated platinum(II) complex having the structure as shown in formula (I). Preferably, the composition further contains a fluorescent dopant material. The fluorescent dopant material is preferably a boron-containing organic molecular light-emitting material. The compound of the present disclosure can phosphorescently sensitize a boron-containing compound.

The present disclosure further provides a formulation. The formulation contains the tetradentate cyclometalated platinum(II) complex having the structure as shown in formula (I) and at least one solvent, or contains the composition described above and at least one solvent.

The solvent is not particularly limited, and may be used, for example, an unsaturated hydrocarbon solvent such as toluene, xylene, mesitylene, tetralin, decahydronaphthalene, dicyclohexane, n-butylbenzene, sec-butylbenzene or tert-butylbenzene, or a halogenated saturated hydrocarbon solvent such as carbon tetrachloride, chloroform, dichloromethane, dichloroethane, chlorobutane, bromobutane, chloropentane, bromopentane, chlorohexane, bromohexane, chlorocyclohexane or bromocyclohexane, or a halogenated unsaturated hydrocarbon solvent such as chlorobenzene, dichlorobenzene or trichlorobenzene, or an ether solvent such as tetrahydrofuran or tetrahydropyran, or an ester solvent such as alkyl benzoate, as well known to those skilled in the art.

The present disclosure further provides a display or lighting apparatus. The apparatus includes at least one organic optoelectronic device each as described above.

**Compared with the prior art, the beneficial effects of the present disclosure are as follows:**
The present disclosure provides a pyridine-fused carbene-based tetradentate cyclometalated platinum(II) complex phosphorescent material. Compared with benzo-fused carbene-based platinum(II) complex, since a pyridine-fused carbene exhibit stronger an electron-withdrawing capacity, an excited state of the pyridine-fused carbene-based tetradentate cyclometalated platinum(II) complex is endowed with a greater proportion of metal-to-pyridine-fused carbene charge transfer states (³MLCT). This facilitates an increase in radiative rate thereof, thereby enhancing lifetime of a device. Materials provided in the present disclosure all exhibit excellent chemical and thermal stability, facilitating fabrication of vacuum-evaporated OLED devices. Organic electroluminescent devices fabricated with compounds of the present disclosure as light-emitting layers demonstrate significant improvements in both current efficiency and lifetime, while also markedly reducing a turn-on voltage. Combining the compounds of the present disclosure with fluorescent dopant materials (boron-containing organic molecular light-emitting materials) can balance transport of holes and electrons, enable more efficient energy transfer between host and guest materials, and enhance light color purity of devices.

### DETAILED DESCRIPTION

The content of the present disclosure is to be described in detail below. The description of constituent elements below is sometimes formed based on representative embodiments or specific examples of the present disclosure, but the disclosure is not limited to such embodiments or examples.

The term "substituted" as used herein is intended to encompass all allowable substituents for organic compounds. In a broad sense, the allowable substituents include acyclic and cyclic, branched and unbranched, carbocyclic and heterocyclic, and aromatic and non-aromatic substituents for organic compounds. Illustrative substituents include, for example, those described below. The allowable substituents for a suitable organic compound may include one or more substituents, which may be identical or different. For the purposes of the present disclosure, the disclosure is not intended to limit, in any manner, allowable substituents for organic compounds. Similarly, the terms "substitution" or "substituted with" carry the implicit condition that such substitution conforms to allowable valence bonds of an atom being substituted and a substituent, and that the substitution results in a stable compound (i.e., a compound that does not spontaneously undergo transformation, such as through rearrangement, cyclization or elimination). It is also anticipated that, in certain aspects, unless explicitly indicated to the contrary, an individual substituent may be further optionally substituted (i.e., the individual substituent may be further substituted or unsubstituted).

In defining various terms, "R¹"-"R⁶," "R^{a}" and "R^{b}" are used as general symbols in the present disclosure to denote various specific substituents. The symbols may be any substituents, not limited to those disclosed in the present disclosure; and when defined as certain substituents in one case, the symbols may also be defined as other substituents in other cases. "R¹", "R²" ... "Rⁿ" (where n is an integer) used in the present disclosure may independently possess one or more of the groups listed above. For example, if R¹ is a linear alkyl group, a hydrogen atom of the alkyl group may optionally be substituted with a hydroxyl group, an alkoxy group, an alkyl group, halogen, etc. Depending on selected groups, a first group may be incorporated within a second group; alternatively, a first group may be suspended from, i.e., connected to, a second group.

The terms "alkyl" and "alkyl group" as used in the present disclosure each refer to a branched or unbranched saturated hydrocarbyl group having 1 to 24 carbon atoms, such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, octadecyl, eicosyl, and tetracosyl. The alkyl group may be cyclic or non-cyclic. The alkyl group may be branched or unbranched. The alkyl group may also be substituted or unsubstituted. For example, the alkyl group may be substituted with one or more substituents, and includes but not limited to optionally substituted alkyl, cycloalkyl, alkoxy, amino, halogen, hydroxyl, nitro, silyl, sulfur-oxo (sulfo-oxo), or mercapto groups as described in the present disclosure. A "lower alkyl" group refers to an alkyl group having one to six (e.g., one to four) carbon atoms.

Throughout the description, the terms "alkyl" and "alkyl group" are each generally used to refer to both unsubstituted and substituted alkyl groups. However, a substituted alkyl group is also specifically mentioned in the present disclosure by identifying particular substituent(s) on the alkyl group. For example, the terms "halogenated alkyl", "halogenated alkyl group", "haloalkyl" or "haloalkyl group" each specifically refer to an alkyl group substituted with one or more halogens (e.g., fluorine, chlorine, bromine or iodine). The terms "alkoxyalkyl" and "alkoxyalkyl group" each specifically refer to an alkyl group substituted with one or more alkoxy groups, as described below. The terms "alkylamino" and "alkylamino group" each specifically refer to an alkyl group substituted with one or more amino groups, as described below. The use of the term "alkyl" or "alkyl group" in one case and a specific term such as "alkyl alcohol" or "alkyl alcohol group" in another case is not intended to imply that the term "alkyl" or "alkyl group" does not encompass the specific term such as "alkyl alcohol" or "alkyl alcohol group".

The terms "cycloalkyl" and "cycloalkyl group" as used in the present disclosure each refer to a non-aromatic carbon-based ring composed of at least three carbon atoms. Examples of a cycloalkyl group include but are not limited to cyclopropyl, cyclobutyl, cyclopentyl, cyclohexyl and cyclononyl.

The term "aryl" and "aryl group" as used herein each refer to a group containing any carbon-based aromatic group. The carbon-based aromatic group includes, but is not limited to, phenyl, naphthyl, phenyl, biphenyl, phenoxyphenyl, anthryl, phenanthryl, etc. The terms "aryl" and "aryl group" each also include "heteroaryl" or "heteroaryl group", and are each defined as a group containing an aromatic group, the aromatic group possessing at least one heteroatom introduced into a ring of the aromatic group. Examples of a heteroatom include but are not limited to a nitrogen atom, an oxygen atom, a sulfur atom and a phosphorus atom. Similarly, the terms "non-heteroaryl" and "non-heteroaryl group" (which are also included in the terms "aryl" and "aryl group") each define groups containing an aromatic group, the aromatic group containing no heteroatoms. An aryl group may be substituted or unsubstituted. The aryl group may be substituted with one or more substituents, a substituent therein including but not limited to alkyl, cycloalkyl, alkoxy, alkenyl, cycloalkenyl, alkynyl, cycloalkynyl, aryl, heteroaryl, aldehyde, amino, carboxyl, ester, halogen, hydroxyl, carbonyl, azido, nitro, silyl, sulfur-oxo (sulfo-oxo) and mercapto. The terms "biaryl" and "biaryl group" each refer to a specific type of aryl group and is included within the definitions of "aryl" and "aryl group". A biaryl group refers to two aryl groups joined together through a fused ring structure, as in naphthalene, or two aryl groups connected by one or more carbon-carbon bonds, as in biphenyl.

Compounds disclosed herein can exhibit desired properties and possess emission spectra and/or absorption spectra that can be modulated by selecting suitable ligands. In another aspect, the present disclosure may exclude any one or more of the compounds, structures, or parts thereof specifically described herein.

The compounds of the present disclosure may be prepared by various methods, including but not limited to those described in embodiments provided herein.

It will be noted that both the general description above and the detailed description below are merely illustrative and explanatory, but are not intended to be limiting. The present disclosure may be more readily understood by reference to specific embodiments and examples included therein.

Before disclosing and describing the compounds, devices and/or methods of the present disclosure, it will be understood that they are not limited to specific synthesis methods (unless otherwise indicated) or specific reagents (unless otherwise indicated), as these are readily variable. It will also be understood that the terms used herein are intended solely for the purpose of describing specific aspects, but are not intended to be limiting. Any methods and materials similar or equivalent to those described herein may be used in the practice or testing, exemplary methods and materials are to be described below. All raw materials and solvents used in synthetic examples are commercially available unless otherwise specified. The solvents are used as received without further processing.

A substrate described herein may be any substrate used in typical organic optoelectronic devices. The substrate may be a glass substrate or a transparent plastic substrate, or may be a substrate of an opaque material such as silicon or stainless steel, or may be a flexible polyimide (PI) film. Different substrates are different in mechanical strength, thermal stability, transparency, surface smoothness and waterproofness; and depending on natures of the different substrates, the different substrates are used in different directions. Materials for a hole injection layer, a hole transport layer and an electron injection layer may be selected from any known relevant materials used in OLED apparatuses, which is not specially limited herein.

### Synthesis Embodiments

Examples of compound synthesis, composition, devices or methods below are provided solely to illustrate general approaches within the field, but are not intended to limit the scope of protection of the present disclosure. While every effort has been made to ensure the accuracy of data (quantities, temperatures, etc.) presented herein, some discrepancies may exist. Unless otherwise specified, all weights are measured separately, temperatures are in degrees Celsius (°C) or at room temperature (RT), and pressures are near atmospheric pressure.

The examples below provide methods for preparing new compounds, but the preparation of such compounds is not limited thereto. In the specialized technical field, since the compounds disclosed in the present disclosure are readily modified and prepared, synthesis of the compounds may be achieved by using the methods listed below or other methods. The following examples are provided merely as illustrations, but are not intended to limit the scope of protection of the present disclosure. Temperatures, catalysts, concentrations, reactants and reaction processes may all be modified, so as to select different conditions for preparing the compounds from various reactants.

¹H NMR (500 MHz) spectra, ¹H NMR (400 MHz) spectra and ¹³C NMR (126 MHz) spectra are measured on an ANANCE III (500 MHz) nuclear magnetic resonance spectrometer. Unless otherwise specified, the NMR spectra are all recorded by using dimethyl sulfoxide-*d₆* (DMSO-ds) or CDCl₃ containing tetramethylsilane (TMS) at a mass concentration of 0.1% as a solvent. For ¹H NMR spectra recorded by using CDCl₃ as a solvent, TMS (δ=0.00 ppm) serves as an internal standard; and for ¹H NMR spectra recorded by using DMSO-*d₆* as a solvent, TMS (δ=0.00 ppm), a residual DMSO peak (δ=2.50 ppm) or a residual water peak (δ=3.33 ppm) serves as an internal standard. In ¹³C NMR spectra, CDCl₃ (δ=77.00 ppm) or DMSO-*d₆* (δ=39.52 ppm) serves as an internal standard. High performance liquid chromatography-mass spectrometry (HPLC-MS) spectra are measured on an Agilent 6210 TOF LC/MS mass spectrometer. High-resolution mass spectrometry (HRMS) spectra are measured on an Agilent 6210 TOF LC/MS liquid chromatography time-of-flight mass spectrometer. In data of the ¹H NMR spectra, s=singlet, d=doublet, t=triplet, q=quartet, p=quintet, m=multiplet, br=broad.

### Synthesis Route

### Embodiment 1: tetradentate cyclometalated platinum(II) complex phosphorescent light-emitting material Pt51

**The synthesis route is as follows:**

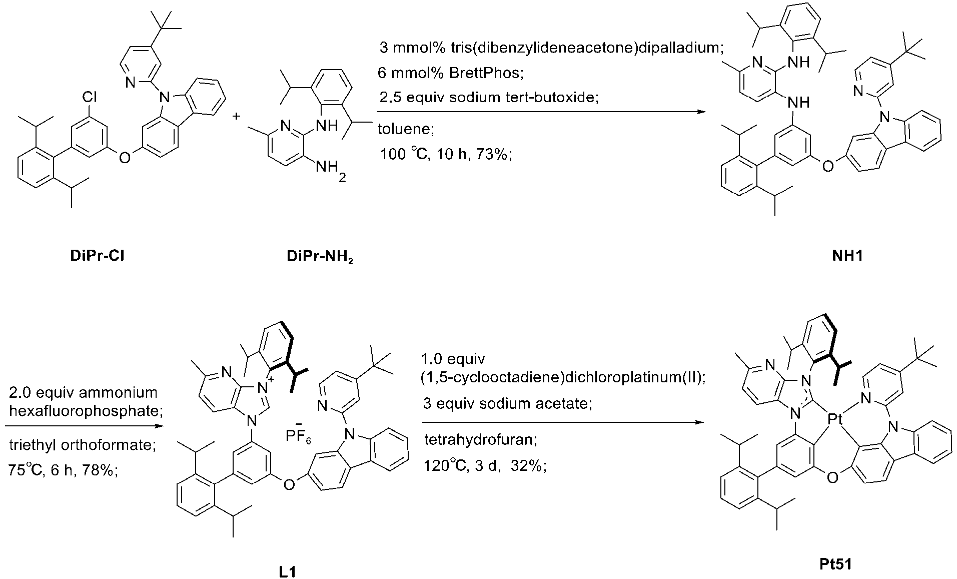

Synthesis of intermediate **NH1: DiPr-NH2** (623 mg, 2.2 mmol, 1.3 equivalents), **DiPr-Cl** (1.0 g, 1.7 mmol, 1.0 equivalent), tris(dibenzylideneacetone)dipalladium (47 mg, 0.05 mmol, 3 mol%), 2-(Dicyclohexylphosphino)-3,6-dimethoxy-2',4',6'-triisopropyl-1,1'-biphenyl (BrettPhos) (55 mg, 0.1 mmol, 6 mol%) and sodium tert-butoxide (408 mg, 4.2 mmol, 2.5 equivalents) are added into a Schlenk tube equipped with a magnetic stir bar; the tube is purged with nitrogen three times, and then toluene (8 mL) is added under a nitrogen atmosphere; the mixture is heated in a 100°C oil bath for reaction for 10 hours and then cooled to room temperature; then, a solvent therein is removed by distillation under reduced pressure, so as to obtain a crude product; and the crude product is purified by silica gel column chromatography (an eluent used therein being a mixture of petroleum ether and ethyl acetate (EA), and a volume ratio of the petroleum ether and the EA ranging from 40:1 to 20:1) to afford 1.03 g of a solid in 73% yield. Structural characterization is not performed, and the solid is used directly for a next step.

Synthesis of ligand **L1: NH1** (1.03 g, 1.2 mmol, 1.0 equivalent) and ammonium hexafluorophosphate (391 mg, 2.4 mmol, 2.0 equivalents) are added into a Schlenk tube with a magnetic stir bar; the tube is purged with nitrogen three times, and then triethyl orthoformate (5 mL) is added under a nitrogen atmosphere; the mixture is heated in a 75°C oil bath for reaction for 6 hours, and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA ranging from 100:1 to 50:1) to afford 900 mg of a solid in 78% yield. A ¹H NMR characterization result for the solid is as follows: ¹H NMR (500 MHz, DMSO-*d₆*) δ 0.89 (d, *J*=6.5 Hz, 6H), 0.99 (d, *J*=6.5 Hz, 6H), 1.09 (d, *J*=6.5 Hz, 6H), 1.14 (d, *J*=6. 5 Hz, 6H), 1.33 (s, 9H), 2.42 (m, *J*=7.0 Hz, 2H), 2.57 (m, *J*=6. 5 Hz, 2H), 2.61 (s, 3H), 7.03 (q, *J*=1.0 Hz, 1H), 7.21 (d, *J*=8.0 Hz, 2H), 7.25 (dd, *J*=8.5, 2.5 Hz, 1H), 7.30-7.37 (m, 2H), 7.44-7.57 (m, 6H), 7. 67-7.75 (m, 3H), 7.78 (d, *J* =8.5 Hz, 1H), 7.85 (t, *J*=2.0 Hz, 1H), 8.25 (d, *J*=8.0 Hz, 1H), 8.34 (d, *J*=8. 5 Hz, 1H), 8.47 (d, *J*=9.0 Hz, 1H), 8.58 (d, *J*=5.0 Hz, 1H), 10.75 (s, 1H).

Synthesis of **Pt51: L1** (900 mg, 0.9 mmol, 1.0 equivalent), (1,5-cyclooctadiene)dichloroplatinum(II) (337 mg, 0.9 mmol, 1.0 equivalent) and sodium acetate (221 mg, 2.7 mmol, 3.0 equivalents) are added into a flask with a magnetic stir bar; the flask is purged with nitrogen three times, and then tetrahydrofuran (8 mL) is added under a nitrogen atmosphere, followed by 30 minutes of nitrogen sparging for deoxygenation; the mixture is heated in a 120°C oil bath for reaction for 44 hours, and then cooled to room temperature; then, a solvent therein is removed by distillation under reduced pressure, so as to obtain a crude product; and the crude product is purified by silica gel column chromatography (an eluent used therein being a mixture of petroleum ether and dichloromethane, and a volume ratio of the petroleum ether and the dichloromethane ranging from 4:1 to 1:1) to afford 304 mg of a yellow solid in 32% yield. A ¹H NMR characterization result for the yellow solid is as follows: ¹H NMR (500 MHz, CDCl₃-*d*) δ 0.77-1.42 (m, 33H), 2.49 (s, 3H), 3.01 (s, 4H), 6.10 (dd, *J*=6.5, 2.0 Hz, 1H), 7.01 (d, *J*=1.5 Hz, 1H), 7.13 (d, *J*=8.5 Hz, 1H), 7.26 (s, 3H), 7. 27-7.31 (m, 3H), 7.32-7.44 (m, 5H), 7.79 (dd, *J*=8.5, 4.0 Hz, 2H), 7.97 (d, *J*=2.0 Hz, 1H), 8.02 (dd, *J*=8.0, 1.5 Hz, 1H), 8.13 (d, *J*=8.5 Hz, 1H), 8.64 (d, *J*=6.0 Hz, 1H).

### Embodiment 2: tetradentate cyclometalated platinum(II) complex phosphorescent light-emitting material Pt52

The synthesis route is as follows:

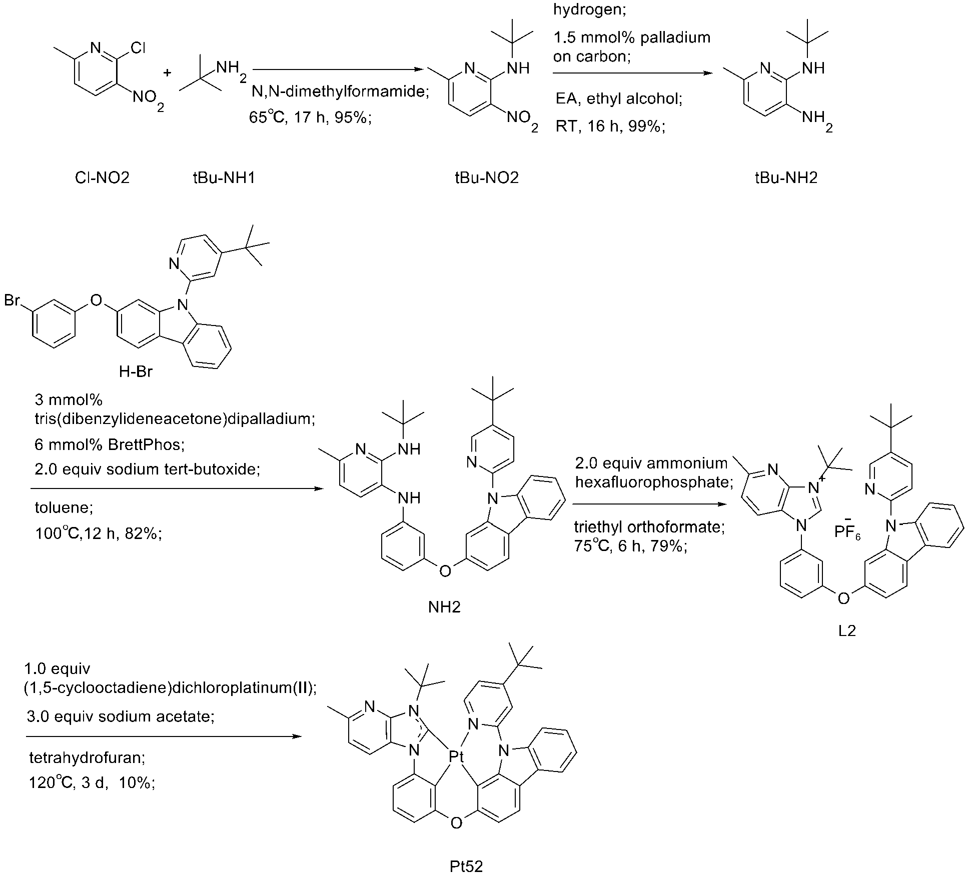

Synthesis of Intermediate **tBu-NO2: Cl-NO2** (1.0 g, 5.8 mmol, 1.0 equivalent) and **tBu-NH1** (1.3 g, 8.68 mmol, 1.5 equivalents) are added into a Schlenk tube equipped with a magnetic stir bar; the tube is purged with nitrogen three times, and then N,N-dimethylformamide (3 mL) is added under a nitrogen atmosphere; the mixture is heated in a 65°C oil bath for reaction for 17 hours, cooled to room temperature, and then extracted by using water and EA to obtain an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA ranging from 40:1 to 20:1) to afford 1.15 g of a solid in 95% yield. Structural characterization is not performed, and the solid is used directly for a next step.

Synthesis of Intermediate **tBu-NH2: tBu-NO2** (1.15 g, 5.55 mmol, 1.0 equivalent) and palladium on carbon (113 mg, 0.11 mmol, 2.0 mmol%) are added into a three-neck flask equipped with a magnetic stir bar, followed by ethanol (15 mL) and EA (10 mL); after reacting for 16 hours in a hydrogen atmosphere, the reaction mixture is filtered through diatomaceous earth, and distillation under reduced pressure is performed to remove a solvent therein to afford 978 mg of a solid in 99% yield. Structural characterization is not performed, and the solid is used directly for a next step.

Synthesis of Intermediate **NH2: tBu-NH2** (500 mg, 2.8 mmol, 1.3 equivalents), **H-Br** (1.01 g, 2.14 mmol, 1.0 equivalent), tris(dibenzylideneacetone)dipalladium (59 mg, 0.064 mmol, 3 mol%), 2-(Dicyclohexylphosphino)-3,6-dimethoxy-2',4',6'-triisopropyl-1,1'-biphenyl (BrettPhos) (69 mg, 0.13 mmol, 6 mol%) and sodium tert-butoxide (514 mg, 5.35 mmol, 2.5 equivalents) are added into a Schlenk tube equipped with a magnetic stir bar; the tube is purged with nitrogen three times, and then toluene (6 mL) is added under a nitrogen atmosphere; after reacting for 12 hours in a 100°C oil bath, the reaction mixture is cooled to room temperature, and then extracted with water and EA to obtain an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA ranging from 30:1 to 10:1) to afford 978 mg of a brown solid in 82% yield.

Synthesis of ligand **L2: NH2** (978 mg, 1.7 mmol, 1.0 equivalent) and ammonium hexafluorophosphate (554 mg, 3.4 mmol, 2.0 equivalents) are added into a Schlenk tube equipped with a magnetic stir bar; the tube is purged with nitrogen three times, and then triethyl orthoformate (5 mL) is added under a nitrogen atmosphere; the mixture is heated in a 75°C oil bath for reaction for 6 hours, and then cooled to room temperature; then, a solvent therein is removed by distillation under reduced pressure, so as to obtain a crude product; and the crude product is purified by silica gel column chromatography (an eluent used therein being a mixture of dichloromethane and EA, and a volume ratio of the dichloromethane and the EA ranging from 30:1 to 10:1) to afford 968 mg of a solid in 79% yield. A ¹H NMR characterization result for the solid is as follows: ¹H NMR (500 MHz, DMSO-*d₆*) δ 1.31 (s, 9H), 1.87 (s, 9H), 2.72 (s, 3H), 7.18 (dd, *J*=8.5, 2.0 Hz, 1H), 7.34 (ddd, *J*=7.5, 7.0, 1.0 Hz, 1H), 7.38-7.42 (m, 1H), 7.44-7.51 (m, 3H), 7.58-7.65 (m, 3H), 7.68-7.76 (m, 3H), 8.23-8.27 (m, 2H), 8.32 (d, *J*=8.5 Hz, 1H), 8.59 (dd, *J*=5.5, 0.5 Hz, 1H), 10.04 (s, 1H).

Synthesis of **Pt52: L2** (600 mg, 1.05 mmol, 1.0 equivalent), (1,5-cyclooctadiene)dichloroplatinum(II) (393 mg, 1.05 mmol, 1.0 equivalent) and sodium acetate (258 mg, 3.15 mmol, 3.0 equivalents) are added into a flask equipped with a magnetic stir bar; the flask is purged with nitrogen three times, and then tetrahydrofuran (5 mL) is added under a nitrogen atmosphere, followed by 30 minutes of nitrogen sparging for deoxygenation; the mixture is heated in a 120°C oil bath for reaction for 44 hours, and then cooled to room temperature; then, a solvent therein is removed by distillation under reduced pressure, so that a crude product is obtained; the crude product is purified by silica gel column chromatography (an eluent used therein being a mixture of petroleum ether and dichloromethane, and a volume ratio of the petroleum ether and the dichloromethane ranging from 4:1 to 1:1) to afford 92 mg of a yellow solid in 10% yield. A ¹H NMR characterization result for the yellow solid is as follows: ¹H NMR (500 MHz, CDCl3-*d*) δ 1.33 (s, 9H), 2.01 (s, 9H), 2.68 (s, 3H), 6.94 (dd, *J*=6.0, 2.0 Hz, 1H), 7.08 (dd, *J*=8.5, 1.0 Hz, 1H), 7.19 (d, *J*=8.5 Hz, 1H), 7.29 (d, *J*=8.0 Hz, 1H), 7.33-7.51 (m, 4H), 7.89 (d, *J*=8.5 Hz, 1H), 7.91 (d, *J*=7.5 Hz, 1H), 8.02-8.13 (m, 2H), 8.27 (d, *J*=8.0 Hz, 1H), 9.21 (d, *J*=6.5 Hz, 1H).

**Embodiment 3:** tetradentate cyclometalated platinum(II) complex phosphorescent light-emitting material Pt46. Synthesis route is as follows:

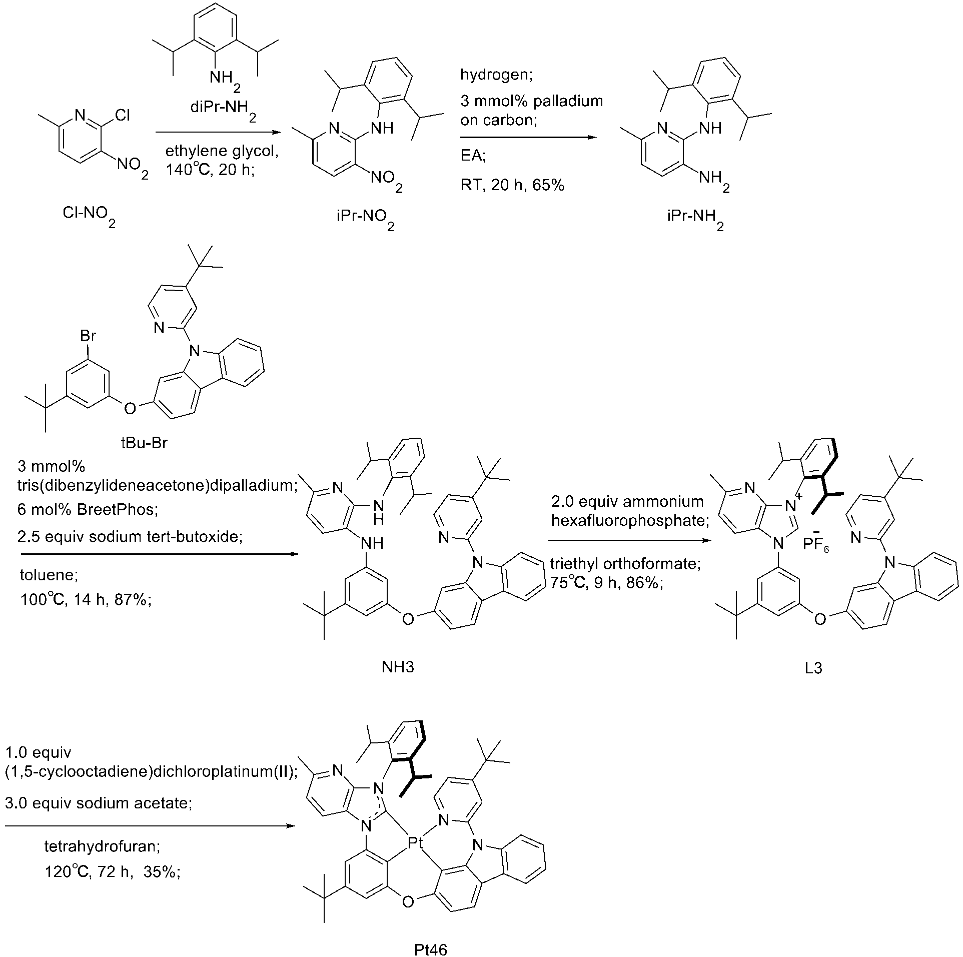

Synthesis of intermediate **iPr-NO₂: Cl-NO2** (10 g, 57.95 mmol, 1.0 equivalent) and **iPr-NH1** (15.41 g, 86.92 mmol, 1.5 equivalent) are added into a three-neck flask; the flask is purged with nitrogen three times, and then ethylene glycol (15 mL) is added; the mixture is heated to 140°C for reaction for 20 hours, and then cooled to room temperature, and the reaction is quenched with water; the reaction mixture is neutralized with NaHCO₃ and extracted with EA (EA) to collect an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA ranging from 100:1 to 30:1) to afford 19 g of a solid. Structural characterization is not performed, and the solid is used directly for a next step.

Synthesis of intermediate **iPr-NH₂: iPr-NO2** (19 g, 71 mmol, 1.0 equivalent) and palladium on carbon (2.5 g, 1.18 mmol, 1.0 mmol%) are added into a single-necked flask equipped with a magnetic stir bar, followed by ethanol (30 mL) and EA (100 mL); after reacting for 20 hours under a hydrogen atmosphere, the reaction mixture is filtered through diatomaceous earth, and distillation under reduced pressure is performed to remove a solvent therein, so that a crude product is obtained; and the crude product is purified by silica gel column chromatography (an eluent used therein being a mixture of petroleum ether and EA, and a volume ratio of the petroleum ether and the EA ranging from 10:1 to 1:1) to afford 10.63 g of a solid in 99% yield. Structural characterization is not performed, and the solid is used directly for a next step.

Synthesis of intermediate **NH3: iPr-NH2** (355 mg, 1.25 mmol, 1.1 equivalents), **tBu-Br** (600 mg, 1.14 mmol, 1.0 equivalent), tris(dibenzylideneacetone)dipalladium (31 mg, 0.034 mmol, 3 mol%), 2-(Dicyclohexylphosphino)-3,6-dimethoxy-2',4',6'-triisopropyl-1,1'-biphenyl (BrettPhos) (37 mg, 0.068 mmol, 6 mol%) and sodium tert-butylate (274 mg, 2.85 mmol, 2.5 equivalents) are added into a Schlenk tube equipped with a magnetic stir bar; the tube is purged with nitrogen three times, and then toluene (6 mL) is added under a nitrogen atmosphere; after reacting for 14 hours in a 100°C oil bath, the reaction mixture is cooled to room temperature, and then extracted with water and EA to obtain an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA ranging from 20:1 to 10:1) to afford 720 mg of a brown solid in 87% yield.

Synthesis of ligand **L3**: **NH2** (720 mg, 0.99 mmol, 1.0 equivalent) and ammonium hexafluorophosphate (323 mg, 1.98 mmol, 2.0 equivalents) are added into a Schlenk tube equipped with a magnetic stir bar; the tube is purged with nitrogen three times, and then triethyl orthoformate (3 mL) is added under a nitrogen atmosphere; after reacting for 9 hours in a 75°C oil bath, the reaction mixture is cooled to room temperature; and distillation under reduced pressure is performed on the reaction mixture to remove a solvent therein, so that a crude product is obtained; and the crude product is purified by silica gel column chromatography (an eluent used therein being a mixture of petroleum ether and EA, and a volume ratio of the petroleum ether and the EA ranging from 3:1 to 1:1) to afford 794 mg of a solid in 86% yield. A ¹H NMR characterization result for the solid is as follows: ¹H NMR (500 MHz, DMSO-*d₆*) δ 0.99 (d, *J*=7.0 Hz, 6H), 1.13 (d, *J*=7.0 Hz, 6H), 1.31 (s, 9H), 1.36 (s, 9H), 2.35-2.41 (m, 2H), 2.60 (s, 3H), 7.22 (dd, *J*=8.0, 2.0 Hz, 1H), 7.35 (td, *J*=7.5, 1.0 Hz, 1H), 7.45-7.56 (m, 7H), 7.64-7.76 (m, 5H), 8.25 (dt, *J*=7.5, 1.0 Hz, 1H), 8.33 (d, *J*=8.5 Hz, 1H), 8.45 (d, *J*=8.5 Hz, 1H), 8.58 (dd, *J*=5.5, 0.5 Hz, 1H), 10.76 (s, 1H).

Synthesis of **Pt46: L2** (670 mg, 0.76 mmol, 1.0 equivalent), (1,5-cyclooctadiene)dichloroplatinum(II) (283 mg, 0.76 mmol, 1.0 equivalent) and sodium acetate (186 mg, 2.27 mmol, 3.0 equivalents) are added into a flask equipped with a magnetic stir bar; the flask is purged with nitrogen three times, and then tetrahydrofuran (5 mL) is added under a nitrogen atmosphere, followed by 30 minutes of nitrogen sparging for deoxygenation; after reacting in a 120°C oil bath for 72 hours, the reaction mixture is cooled to room temperature; then, distillation under reduced pressure is performed on the reaction mixture to remove a solvent therein, so that a crude product is obtained; and the crude product is purified by silica gel column chromatography (an eluent used therein being a mixture of petroleum ether and dichloromethane, and a volume ratio of the petroleum ether and the dichloromethane ranging from 2:1 to 1:1) to afford 250 mg of a yellow solid in 35% yield. A ¹H NMR characterization result for the yellow solid is as follows: ¹H NMR (500 MHz, CDCl₃-*d*) δ 1.26 (s, 22H), 1.49 (s, 9H), 2.52 (s, 3H), 3.07 (s, 2H), 6.07 (dd, *J*=6.5, 2.0 Hz, 1H), 7.15-7.25 (m, 3H), 7.29-7.44 (m, 4H), 7.56 (d, *J*=1.5 Hz, 1H), 7.76-7.79 (m, 2H), 7.94 (d, *J*=2.0 Hz, 1H), 8.01 (dd, *J*=7.5, 1.5 Hz, 1H), 8.26 (d, *J*=8.0 Hz, 1H), 8.58 (d, *J*=6.5 Hz, 1H).

### Embodiment 4: tetradentate cyclometalated platinum(II) complex phosphorescent light-emitting material Pt47

The synthesis route is as follows:

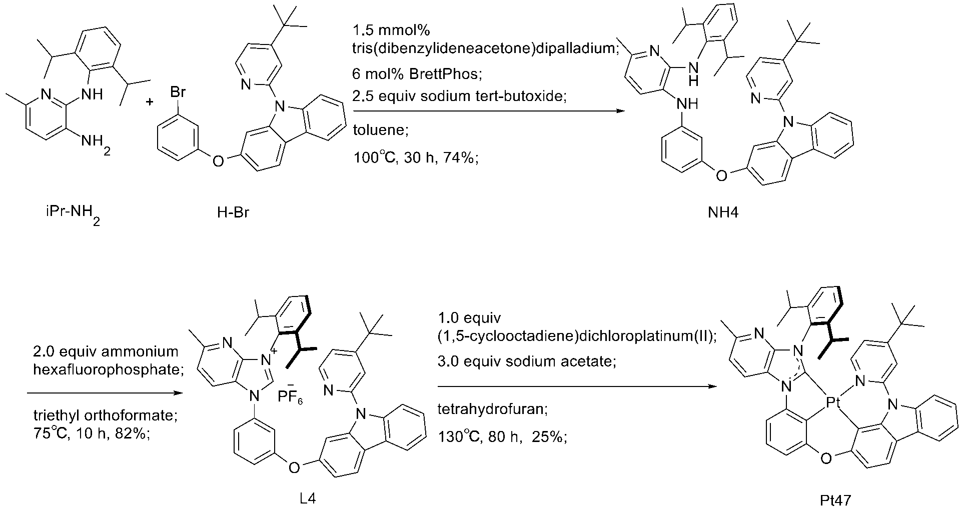

**Pt47** is synthesized with reference to the steps and reaction conditions for synthesizing compound **Pt46.** A target product is obtained as a yellow solid (3 g, 20% yield). A ¹H NMR characterization result for the yellow solid is as follows: ¹H NMR (500 MHz, CDCl₃-*d*) δ 0.84-1.27 (m, 22H), 2.51 (s, 3H), 3.04 (s, 2H), 6.08 (dd, *J*=6.5, 2.0 Hz, 1H), 7.08-7.25 (m, 3H), 7.29-7.46 (m, 5H), 7.52 (dd, *J*=7.5, 1.0 Hz, 1H), 7.78 (dd, *J*=8.0, 2.5 Hz, 2H), 7.94 (d, *J*=2.0 Hz, 1H), 8.01 (dd, *J*=7.5, 1.0 Hz, 1H), 8.28 (d, *J*=8.0 Hz, 1H), 8.59 (d, *J*=7.0 Hz, 1H).

### Embodiment 5: tetradentate cyclometalated platinum(II) complex phosphorescent light-emitting material Pt48

The synthesis route is as follows:

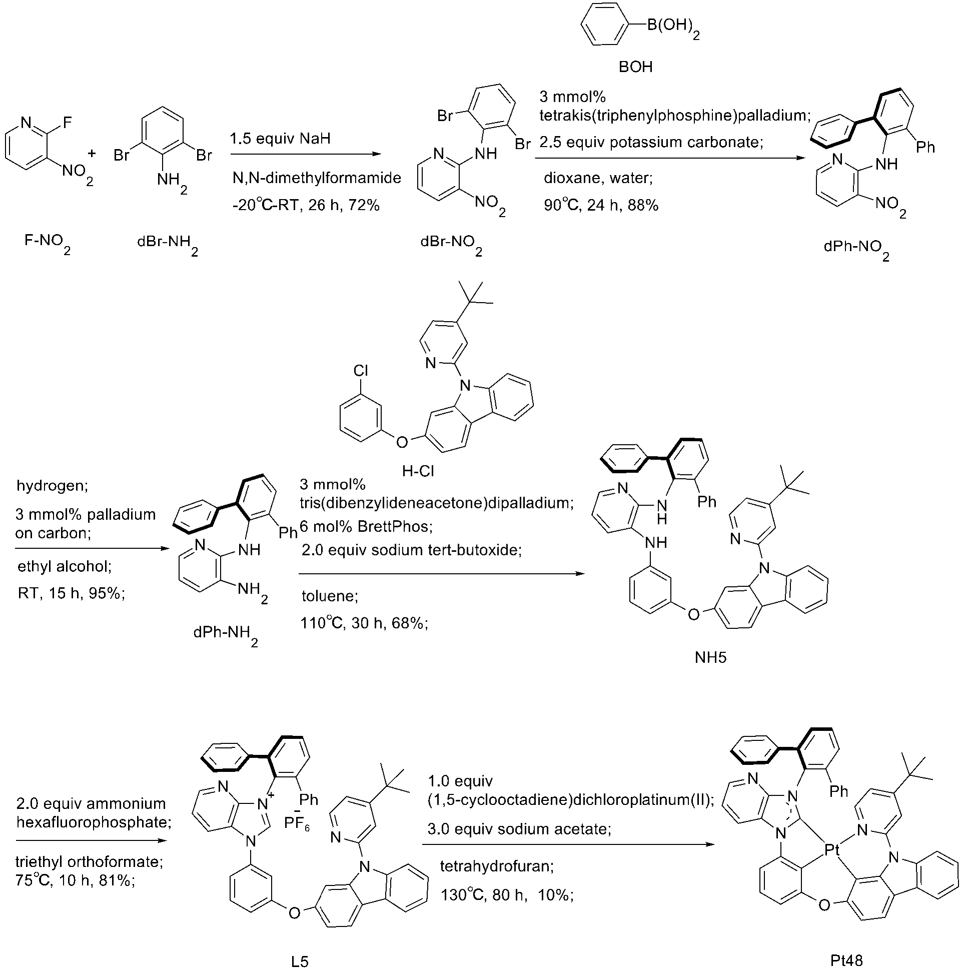

Synthesis of intermediate **dBr-NO2: F-NO2** (500 mg, 3.52 mmol, 1.0 equivalent) is added into a Schlenk tube equipped with a magnetic stir bar; the tube is purged with nitrogen three times, and then N,N-Dimethylformamide (10 mL) is added under a nitrogen atmosphere; the mixture is cooled to -20°C, and then NaH is added therein, followed by **dBr-NH₂** (1.15 g, 4.57 mmol, 1.3 equivalents); after reacting at room temperature for 26 hours, the reaction mixture is extracted with water and EA to collect an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA is 20:1) to afford 946 mg of a yellow solid in 72% yield. Structural characterization is not performed, and the yellow solid is used directly for a next step.

Synthesis of intermediate **dPh-NO2: dBr-NO2** (500 mg, 1.34 mmol, 1.0 equivalent), **BOH** (489 mg, 4.01 mmol, 3.0 equivalents), tetrakis(triphenylphosphine)palladium (46 mg, 0.04 mmol, 3.0 mmol%) and potassium carbonate (463 mg, 3.35 mmol, 2.5 equivalents) are added into a Schlenk tube equipped with a magnetic stir bar; the tube is purged with nitrogen three times, and then 1,4-dioxane (4 mL) and water (1 mL) are added; after reacting at 90°C for 24 hours, the reaction mixture is cooled to room temperature, and then extracted with water and EA to collect an organic phase; distillation under reduced pressure is performed on the organic phase to remove a solvent therein, so that a crude product is obtained; and the crude product is purified by silica gel column chromatography (an eluent used therein being a mixture of petroleum ether and EA, and a volume ratio of the petroleum ether and the EA ranging from 20:1 to 10:1) to afford 380 mg of a yellow solid in 77% yield. Structural characterization is not performed, and the yellow solid is used directly for a next step.

Synthesis of intermediate **dPh-NH₂: dPh-NO2** (380 mg, 1.03 mmol, 1.0 equivalent) and palladium on carbon (33 mg, 0.031 mmol, 3.0 mmol%) are added into a single-necked flask equipped with a magnetic stir bar, followed by ethanol (10 mL) and EA (2 mL); after reacting for 15 hours under a hydrogen atmosphere, the reaction mixture is filtered through diatomaceous earth, and distillation under reduced pressure is performed on the reaction mixture to remove a solvent therein, so that a crude product is obtained; and the crude product is purified by silica gel column chromatography (an eluent used therein being a mixture of petroleum ether and EA, and a volume ratio of the petroleum ether and the EA ranging from 10:1 to 5:1) to afford 330 mg of a brown solid in 95% yield. Structural characterization is not performed, and the yellow solid is used directly for a next step.

Synthesis of intermediate **NH5: dPh-NH₂** (330 mg, 0.98 mmol, 1.0 equivalent), **H-Cl** (418 mg, 0.98 mmol, 1.0 equivalent), tris(dibenzylideneacetone)dipalladium (27 mg, 0.03 mmol, 3 mol%), 2-(Dicyclohexylphosphino)-3,6-dimethoxy-2',4',6'-triisopropyl-1,1'-biphenyl (BrettPhos) (32 mg, 0.06 mmol, 6 mol%) and sodium tert-butylate (188 mg, 1.96 mmol, 2.0 equivalents) are added into a Schlenk tube equipped with a magnetic stir bar; the tube is purged with nitrogen three times, and then toluene (4 mL) is added under a nitrogen atmosphere; after reacting for 30 hours in a 110°C oil bath, the reaction mixture is cooled to room temperature, and then extracted with water and EA to collect an organic phase; distillation under reduced pressure is performed on the organic phase to remove a solvent therein, so that a crude product is obtained; the crude product is purified by silica gel column chromatography (an eluent used therein being a mixture of petroleum ether and EA, and a volume ratio of the petroleum ether and the EA ranging from 20:1 to 10:1) to afford 490 mg of a brown solid in 68% yield.

Synthesis of ligand **L5: NH5** (490 mg, 0.67 mmol, 1.0 equivalent) and ammonium hexafluorophosphate (219 mg, 1.35 mmol, 2.0 equivalents) are added into a Schlenk tube equipped with a magnetic stir bar; the tube is purged with nitrogen three times, and then triethyl orthoformate (4 mL) is added under a nitrogen atmosphere; after reacting for 10 hours in a 75°C oil bath, the reaction mixture is cooled to room temperature; then, distillation under reduced pressure is performed on the reaction mixture to remove a solvent therein, so that a crude product is obtained; and the crude product is purified by silica gel column chromatography (an eluent used therein being a mixture of dichloromethane and EA, and a volume ratio of the dichloromethane and EA ranging from 50:1 to 10:1) to afford 473 mg of a brown solid in 81% yield. A ¹H NMR characterization result for the brown solid is as follows: ¹H NMR (500 MHz, DMSO-*d₆*) δ 1.29 (s, 9H), 7.11-7.14 (m, 10H), 7.17 (dd, J=8.5, 2.0 Hz, 1H), 7.21 (ddd, J=8.0, 2.2, 0.9 Hz, 1H), 7.34-7.38 (m, 1H), 7.40 (ddd, J=8.5, 2.5, 0.5 Hz, 1H), 7.46-7.51 (m, 3H), 7.67-7.77 (m, 6H), 7.94 (t, J=7.5 Hz, 1H), 8.28 (dt, J=7.5, 1.0 Hz, 1H), 8.34-8.40 (m, 2H), 8.57-8.62 (m, 1H), 8.67 (dd, J=5.0, 1.5 Hz, 1H), 10.65 (s, 1H).

Synthesis of **Pt48: L5** (473 mg, 0.54 mmol, 1.0 equivalent), (1,5-cyclooctadiene)dichloroplatinum(II) (200 mg, 0.54 mmol, 1.0 equivalent) and sodium acetate (133 mg, 1.62 mmol, 3.0 equivalents) are added into a flask equipped with a magnetic stir bar; the flask is purged with nitrogen three times, and then tetrahydrofuran (5 mL) is added under a nitrogen atmosphere, followed by 30 minutes of nitrogen sparging for deoxygenation; after reacting for 80 hours in a 125°C oil bath, the reaction mixture is cooled to room temperature; distillation under reduced pressure is performed on the reaction mixture to remove a solvent therein, so that a crude product is obtained; and the crude product is purified by silica gel column chromatography (an eluent used therein being a mixture of petroleum ether and dichloromethane, and a volume ratio of the petroleum ether and the dichloromethane ranging from 2:1 to 1:1) to afford 50 mg of a yellow solid in10% yield. A ¹H NMR characterization result for the yellow solid is as follows: ¹H NMR (500 MHz, CDCl₃-*d*) δ 1.31 (s, 9H), 6.23 (dd, *J*=6.5, 2.0 Hz, 1H), 6.59-7.25 (m, 12H), 7.30-7.45 (m, 5H), 7.48-7.56 (m, 3H), 7.77 (d, *J*=8.0 Hz, 1H), 8.08-8.12 (m, 3H), 8.17 (dd, *J*=5.0, 1.5 Hz, 1H), 8.20 (dd, *J*=8.0, 1.0 Hz, 1H), 8.98 (d, *J*=6.0 Hz, 1H).

### Embodiment 6: tetradentate cyclometalated platinum(II) complex phosphorescent light-emitting material Pt49

**The synthesis route is as follows**:

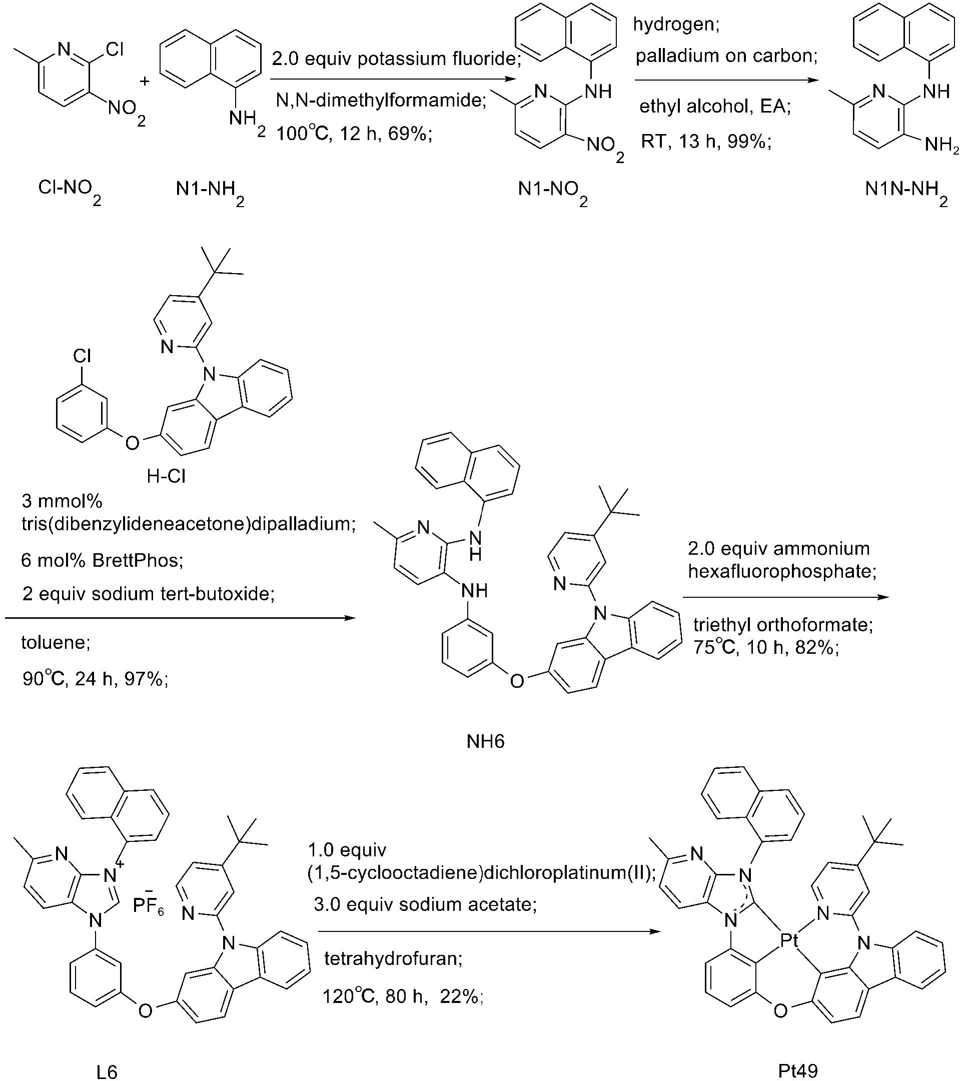

Synthesis of intermediate **N1-NO₂: Cl-NO₂** (1.0 g, 5.79 mmol, 1.0 equivalent) and **N1-NH₂** (1.24 g, 8.69 mmol, 1.5 equivalents) are added into a three-neck flask; the flask is purged with nitrogen three times, and then N,N-dimethylformamide (3 mL) is added; after reacting at 100°C for 12 hours, the reaction mixture is cooled to room temperature, and then extracted with water and EA to collect an organic phase; distill under reduced pressure is performed on the organic phase to obtain a crude product; the crude product is purified by silica gel column chromatography (an eluent used therein being a mixture of petroleum ether and EA, and a volume ratio of the petroleum ether and the EA ranging from 20:1 to 10:1) to afford 1.12 g of a yellow solid in yield 69%. Structural characterization is not performed, and the yellow solid is used directly for a next step.

Synthesis of intermediate **N1N-NH₂: N1-NO₂** (1.12 g, 4.01 mmol, 1.0 equivalent) and palladium on carbon (128 mg, 0.12 mmol, 3.0 mmol%) are added into a single-necked flask equipped with a magnetic stir bar, followed by ethanol (10 mL) and EA (3 mL); after reacting for 13 hours under a hydrogen atmosphere, the reaction mixture is filtered through diatomaceous earth and then subjected to distillation under reduced pressure, so that a crude product is obtained; and the crude product is purified by silica gel column chromatography (an eluent used therein being a mixture of petroleum ether and EA, and a volume ratio of the petroleum ether and the EA ranging from 10:1 to 5:1) to afford 990 mg of a gray solid in 99% yield. Structural characterization is not performed, and the gray solid is used directly for a next step.

Synthesis of intermediate **NH6: N1N-NH₂** (321 mg, 1.29 mmol, 1.1 equivalents), **H-Cl** (500 mg, 1.17 mmol, 1.0 equivalent) and tris(dibenzylideneacetone)dipalladium (32 mg, 0.035 mmol, 3 mol%), 2-(Dicyclohexylphosphino)-3,6-dimethoxy-2',4',6'-triisopropyl-1,1'-biphenyl (BrettPhos) (38 mg, 0.07 mmol, 6 mol%) and sodium tert-butylate (225 mg, 2.34 mmol, 2.0 equivalents) are added into a Schlenk tube with a magnetic stir bar; the tube is purged with nitrogen three times, and then toluene (4 mL) is added under a nitrogen atmosphere; after reacting for 24 hours in a 100°C oil bath, the reaction mixture is cooled to room temperature, and then extracted with water and EA to collect an organic phase; distillation under reduced pressure is performed on the organic phase to obtain a crude product; and the crude product is purified by silica gel column chromatography (an eluent used therein being a mixture of petroleum ether and EA, and a volume ratio of the petroleum ether and the EA ranging from 20:1 to 10:1) to afford 723 mg of a brown solid in 97% yield.

Synthesis of ligand **L6: NH6** (723 mg, 1.13 mmol, 1.0 equivalent) and ammonium hexafluorophosphate (368 mg, 2.26 mmol, 2.0 equivalents) are added into a Schlenk tube equipped with a magnetic stir bar; the tube is purged with nitrogen three times, and then triethyl orthoformate (4 mL) is added under a nitrogen atmosphere; after reacting for 10 hours in a 75°C oil bath, the reaction mixture is cooled to room temperature, and then subjected to distillation under reduced pressure to remove a solvent therein, so that a crude product is obtained; and the crude product is purified by silica gel column chromatography (an eluent used therein being a mixture of dichloromethane and EA, and a volume ratio of the dichloromethane and EA ranging from 50:1 to 20:1) to afford 740 mg of a brown solid in 82% yield. A ¹H NMR characterization result for the brown solid is as follows: ¹H NMR (500 MHz, DMSO-*d₆*) δ 1.30 (s, 9H), 2.53 (s, 3H), 7.22 (dd, *J*=8.0, 2.0 Hz, 1H), 7.34 (t, *J*=7.5 Hz, 1H), 7.46-7.48 (m, 2H), 7.52 (d, *J*=2.0 Hz, 1H), 7.59 (ddd, *J*=8.0, 7.0, 1.0 Hz, 1H), 7.65 (t, *J*=2.5 Hz, 1H), 7.67-7.75 (m, 7H), 7.79-7.83 (m, 2H), 7.97 (dd, *J*=7.5, 2.0 Hz, 1H), 8.19 (d, *J*=8.0 Hz, 1H), 8.24 (d, *J*=7.5 Hz, 1H), 8.33 (d, *J*=8.5 Hz, 2H), 8.46 (d, *J*=8.5 Hz, 1H), 8.59 (d, *J*=5.0 Hz, 1H), 10.73 (s, 1H).

Synthesis of **Pt49: L6** (500 mg, 0.63 mmol, 1.0 equivalent), (1,5-cyclooctadiene)dichloroplatinum(II) (214 mg, 0.57 mmol, 1.0 equivalent) and sodium acetate (140 mg, 1.71 mmol, 3.0 equivalents) are added into a flask equipped with a magnetic stir bar; the flask is purged with nitrogen three times, and then tetrahydrofuran (5 mL) is added, followed by 30 minutes of nitrogen sparging for deoxygenation; after reacting for 80 hours in a 125°C oil bath, the reaction mixture is cooled to room temperature, and then subjected to distillation under reduced pressure, so that a crude product is obtained; and the crude product is purified by silica gel column chromatography (an eluent used therein being a mixture of petroleum ether and dichloromethane, and a volume ratio of the petroleum ether and the dichloromethane ranging from 1:1 to 1:3) to afford 101 mg of a yellow solid in 22% yield. A ¹H NMR characterization result for the yellow solid is as follows: ¹H NMR (500 MHz, CDCl₃-*d*) δ 1.10 (s, 9H), 2.52 (s, 3H), 7.18 (dd, *J*=8.0, 1.0 Hz, 1H), 7.28 (s, 1H), 7.29-7.36 (m, 3H), 7.36-7.44 (m, 3H), 7.52 (d, *J*=8.0 Hz, 2H), 7.64 (br, 2H), 7.72-7.87 (m, 5H), 8.00 (d, *J*=7.5 Hz, 2H), 8.26 (br, 1H), 8.33 (d, *J*=8.5 Hz, 1H).

### Embodiment 7: tetradentate cyclometalated platinum(II) complex phosphorescent light-emitting material Pt50

**The synthesis route is as follows:**

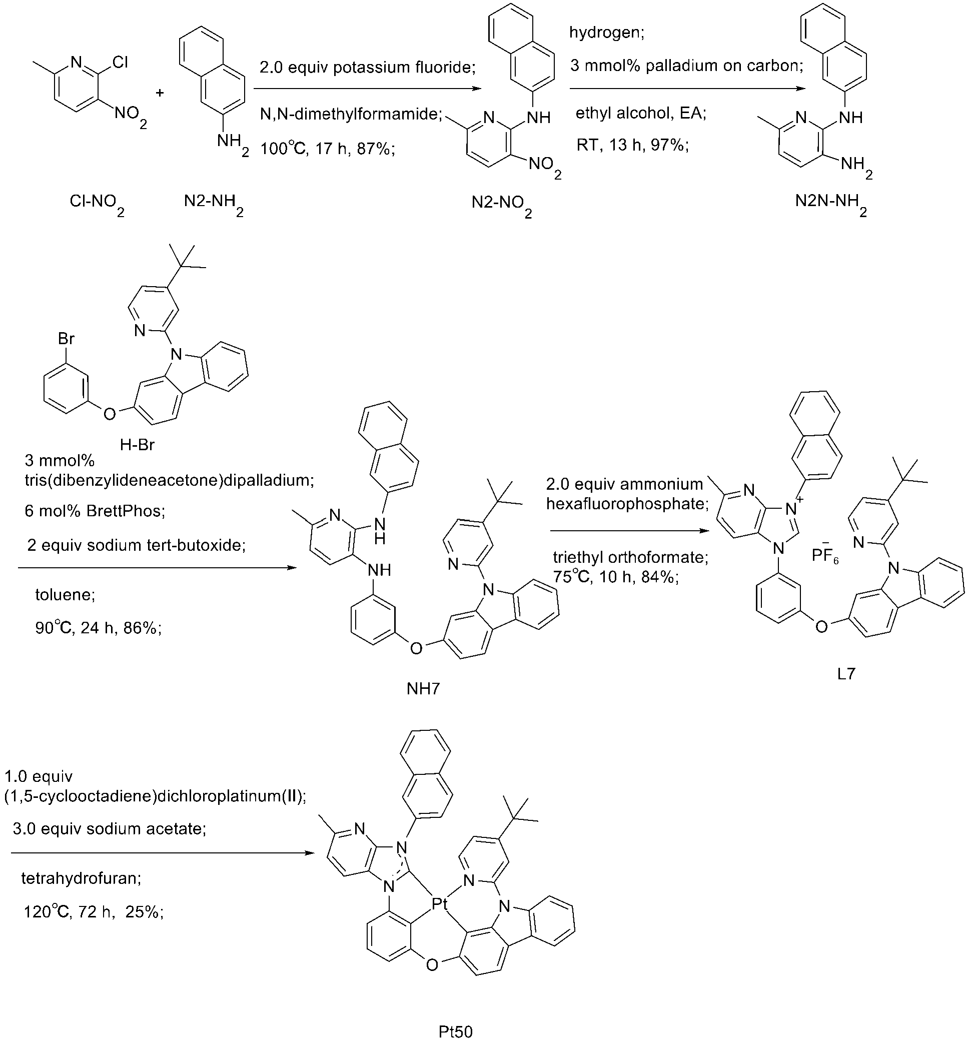

**Pt50** is synthesized with reference to the steps and reaction conditions for synthesizing compound **Pt49.** A target product is obtained as a yellow solid (120 mg, 25% yield). A ¹H NMR characterization result for the yellow solid is as follows: ¹H NMR (500 MHz, CDCl₃-*d*) δ 0.75 (s, 9H), 2.67 (s, 3H), 5.63 (s, 1H), 7.22 (dd, J=8.0, 1.0 Hz, 1H), 7.28-7.54 (m, 9H), 7.68 (d, J=8.0 Hz, 2H), 7.81 (d, J=8.0 Hz, 1H), 7.86 (d, J=8.5 Hz, 1H), 7.89-8.09 (m, 3H), 8.28 (d, J=8.0 Hz, 1H), 8.37-8.40 (m, 2H).

### Embodiment 8: tetradentate cyclometalated platinum(II) complex phosphorescent light-emitting material Pt171

**The synthesis route is as follows:**

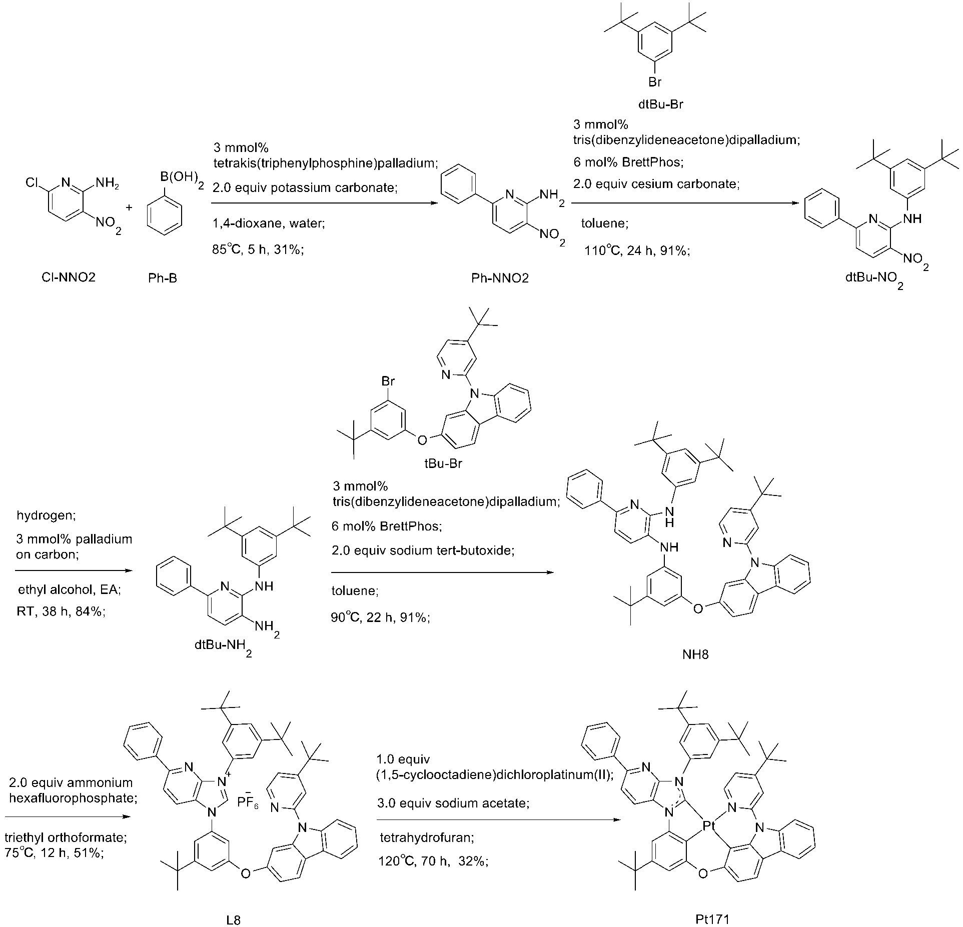

**Pt171** is synthesized with reference to the steps and reaction conditions for synthesizing compound **Pt46.** A target product is obtained as a yellow solid (84 mg, 32% yield). A ¹H NMR characterization result for the yellow solid is as follows: ¹H NMR (500 MHz, CDCl₃-*d*) δ 1.21-1.52 (m, 36H), 6.15 (dd, *J*=6.5, 2.0 Hz, 1H), 7.25 (d, *J*=1.5 Hz, 1H), 7.34-7.49 (m, 8H), 7.62 (d, *J*=1.5 Hz, 1H), 7.78 (dd, *J*=7.5, 1.5 Hz, 1H), 7.88 (d, *J*=8.5 Hz, 2H), 7.94-7.97 (m, 2H), 8.05-8.08 (m, 1H), 8.11-8.14 (m, 2H), 8.50 (d, *J*=8.5 Hz, 1H), 8.75 (d, *J*=6.5 Hz, 1H).

### Embodiment 9: tetradentate cyclometalated platinum(II) complex phosphorescent light-emitting material Pt53

**The synthesis route is as follows:**

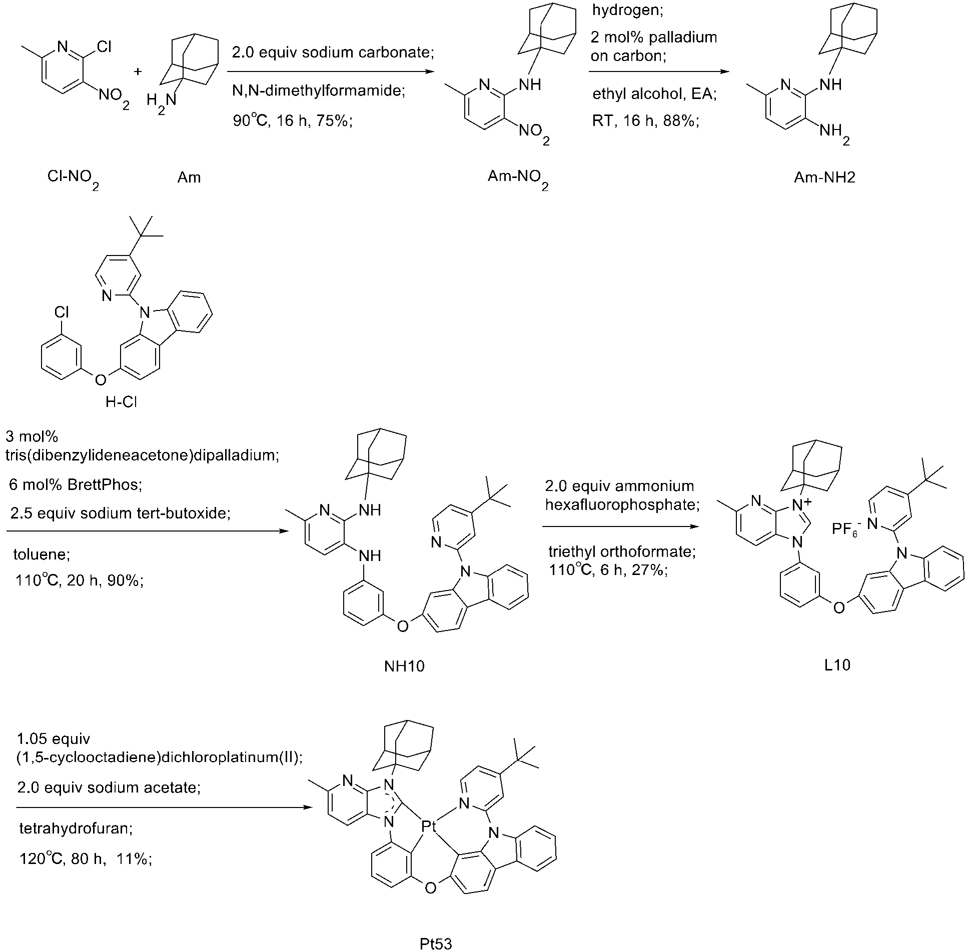

**Pt53** is synthesized with reference to the steps and reaction conditions for synthesizing compound **Pt49.** A target product is obtained as a yellow solid (94 mg, 11% yield). Molecular mass [M+H]⁺: 851.2.

### Embodiment 10: tetradentate cyclometalated platinum(II) complex phosphorescent light-emitting material Pt54

**The synthesis route is as follows:**

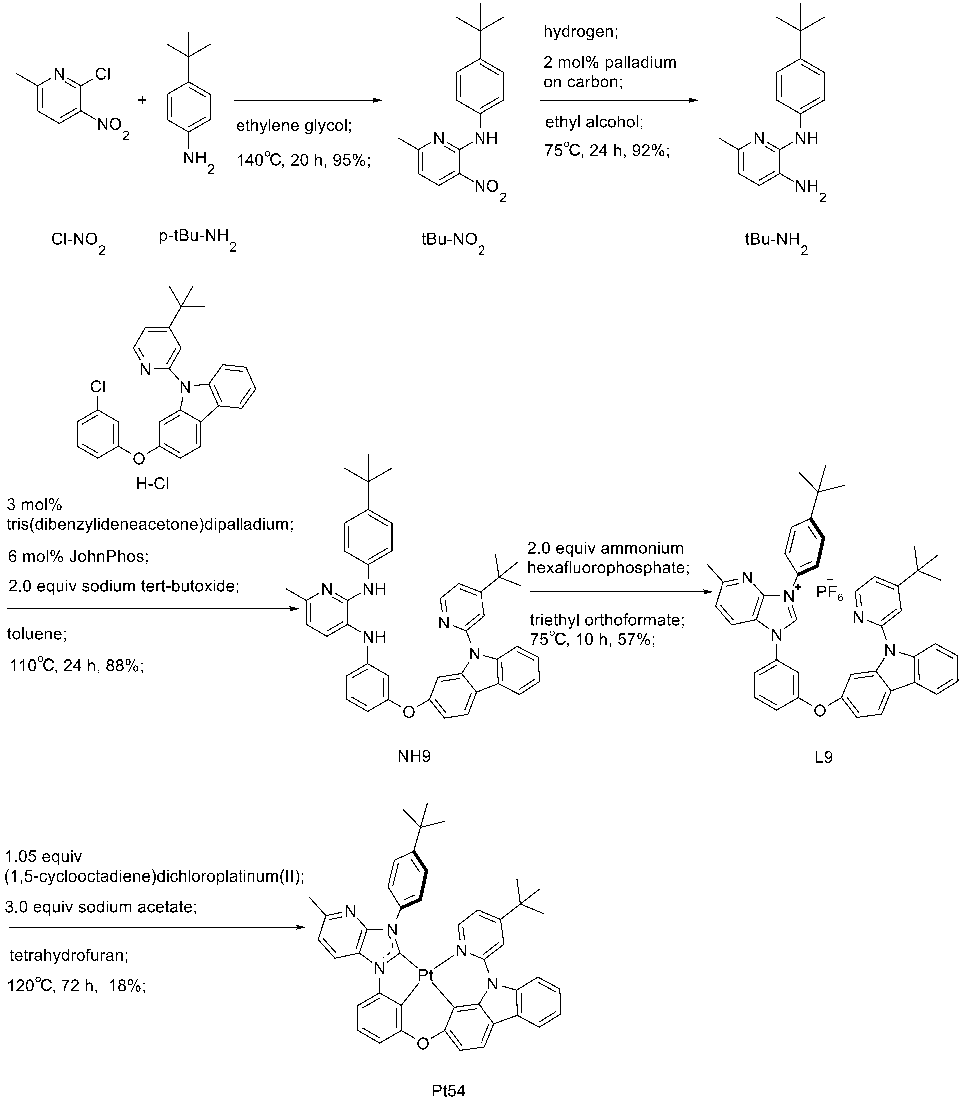

**Pt54** is synthesized with reference to the steps and reaction conditions for synthesizing compound **Pt49.** A target product is obtained as a yellow solid (87 mg, 18% yield). A ¹H **NMR** characterization result for the yellow solid is as follows: ¹H NMR (500 MHz, CDCl₃-*d*) δ 1.07 (s, 9H), 1.27 (s, 9H), 2.64 (s, 3H), 6.15 (dd, *J*=6.5, 2.0 Hz, 1H), 7.18 (dd, *J*=8.0, 1.0 Hz, 1H), 7.24 (s, 1H), 7.27-7.42 (m, 6H), 7.45 (d, *J*=8.5 Hz, 1H), 7.69 (d, *J*=8.0 Hz, 1H), 7.75 (d, *J*=2.0 Hz, 1H), 7.84-7.88 (m, 3H), 8.06 (dd, *J*=7.5, 1.5 Hz, 1H), 8.24 (d, *J*=8.0 Hz, 1H), 8.59 (d, *J*=6.5 Hz, 1H).

### Embodiment 11: synthesis of Pt3

**Pt3** is synthesized with reference to the steps and reaction conditions for synthesizing compound **Pt51.** A target product is obtained as a yellow solid (75 mg, 26% yield). Molecular mass [M+H]⁺: 919.4.

### Embodiment 12: synthesis of Pt6

**Pt6** is synthesized with reference to the steps and reaction conditions for synthesizing compound **Pt51.** A target product is obtained as a yellow solid (72 mg, 16% yield). Molecular mass [M+H]⁺: 1051.4.

### Embodiment 13: synthesis of Pt20

**Pt20** is synthesized with reference to the steps and reaction conditions for synthesizing compound **Pt51.** A target product is obtained as a yellow solid (63 mg, 22% yield). Molecular mass [M+H]⁺: 933.4.

### Embodiment 14: synthesis of Pt41

**Pt41** is synthesized with reference to the steps and reaction conditions for synthesizing compound **Pt51.** A target product is obtained as a yellow solid (67 mg, 32% yield). Molecular mass [M+H]⁺: 905.4.

### Embodiment 15: synthesis of Pt71

**Pt71** is synthesized with reference to the steps and reaction conditions for synthesizing compound **Pt51.** A target product is obtained as a yellow solid (52 mg, 28% yield). Molecular mass [M+H]⁺: 1107.5.

### Embodiment 16: synthesis of Pt72

**Pt72** is synthesized with reference to the steps and reaction conditions for synthesizing compound **Pt51.** A target product is obtained as a yellow solid (58 mg, 38% yield). Molecular mass [M+H]⁺: 1135.6.

### Embodiment 17: synthesis of Pt76

**Pt76** is synthesized with reference to the steps and reaction conditions for synthesizing compound **Pt51.** A target product is obtained as a yellow solid (60 mg, 39% yield). Molecular mass [M+H]⁺: 993.5.

### Embodiment 18: synthesis of Pt80

**Pt80** is synthesized with reference to the steps and reaction conditions for synthesizing compound **Pt51.** A target product is obtained as a yellow solid (53 mg, 27% yield). Molecular mass [M+H]⁺: 1063.5. **Embodiment 19: synthesis of Pt81**

**Pt81** is synthesized with reference to the steps and reaction conditions for synthesizing compound **Pt51.** A target product is obtained as a yellow solid (42 mg, 28% yield). Molecular mass [M+H]⁺: 1205.5.

### Embodiment 20: synthesis of Pt102

**Pt102** is synthesized with reference to the steps and reaction conditions for synthesizing compound **Pt51.** A target product is obtained as a yellow solid (37 mg, 22% yield). Molecular mass [M+H]⁺: 970.5.

### Embodiment 21: synthesis of Pt111

**Pt111** is synthesized with reference to the steps and reaction conditions for synthesizing compound **Pt51.** A target product is obtained as a yellow solid (34 mg, 24% yield). Molecular mass [M+H]⁺: 909.4.

### Embodiment 22: synthesis of Pt174

**Pt174** is synthesized with reference to the steps and reaction conditions for synthesizing compound **Pt51.** A target product is obtained as a yellow solid (39 mg, 31% yield). Molecular mass [M+H]⁺: 1127.5.

### Embodiment 23: synthesis of Pt183

**Pt183** is synthesized with reference to the steps and reaction conditions for synthesizing compound **Pt51.** A target product is obtained as a yellow solid (38 mg, 27% yield). Molecular mass [M+H]⁺: 1131.5.

### Theoretical Calculation Explanation

Geometric structures of ground-state (S₀) molecules are optimized by using density functional theory (DFT). DFT calculations are performed using the Becke, 3-parameter, Lee-Yang-Parr functional (B3LYP functional), with the 6-31G(d) basis set for C, H, O and N atoms and the LANL2DZ basis set for Pt atoms.

**Table 1. Frontier orbital energy levels of selected metal complexes**

| Metal Complex | Lowest Unoccupied Molecular Orbital (LUMO)/eV | Highest Occupied Molecular Orbital (HOMO)/eV | Gap/eV |
|---|---|---|---|
| Pt3 | 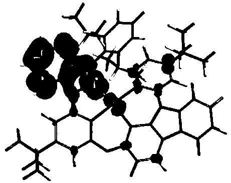 -1.44 eV | 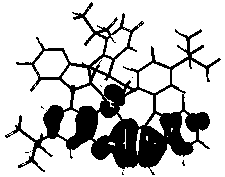 -4.74 eV | 3.30 eV |
| Pt6 | 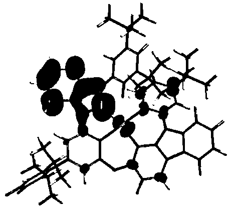 -1.45 eV | 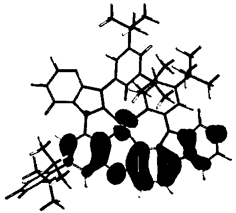 -4.76 eV | 3.31 eV |
| Pt20 | 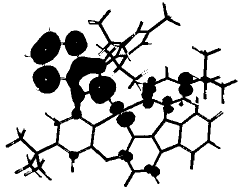 -1.42 eV | 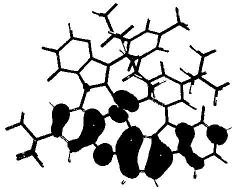 -4.73 eV | 3.31 eV |
| Pt41 | 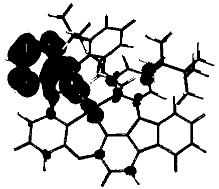 -1.45 eV | 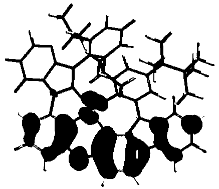 -4.75 eV | 3.30 eV |
| Pt71 | 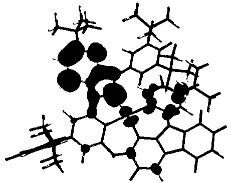 -1.40 eV | 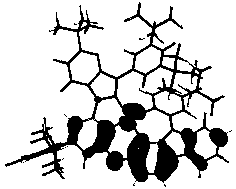 -4.74 eV | 3.34 eV |
| Pt76 | 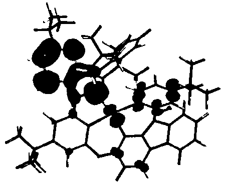 -1.37 eV | 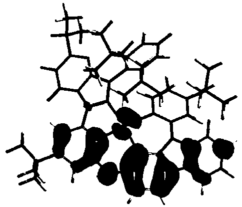 -4.73 eV | 3.36 eV |
| Pt81 | 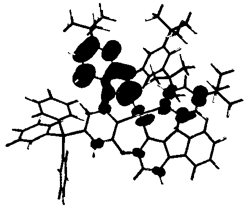 -1.37 eV | 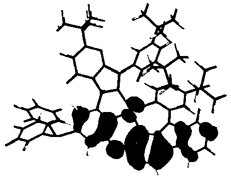 -4.70 eV | 3.33 eV |
| Pt102 | 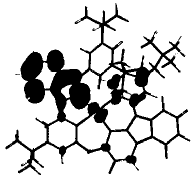 -1.41 eV | 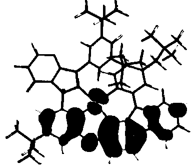 -4.70 eV | 3.29 eV |
| Pt111 | 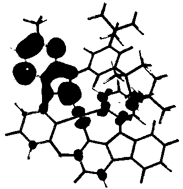 -1.38 eV | 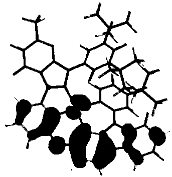 -4.68 eV | 3.30 eV |
| Pt174 | 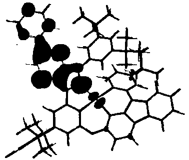 -1.56 eV | 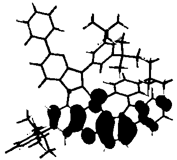 -4.76 eV | 3.20 eV |
| Pt176 | 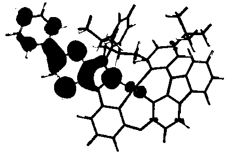 -1.57 eV | 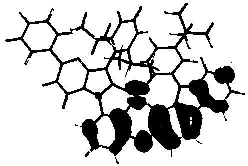 -4.75 eV | 3.18 eV |
| Pt183 | 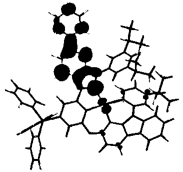 -1.52 eV | 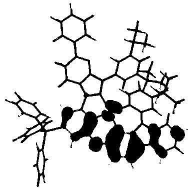 -4.73 eV | 3.21 eV |

It can be seen from the calculation data shown in Table 1 that, the materials provided in the present disclosure all possess large energy gaps (>3.10 eV), meeting the requirements for blue light-emitting materials. Furthermore, energy levels of frontier orbitals (HOMO and LUMO) of the platinum(II) complexes may be tuned by adjusting a ligand structure.

### Photophysical Properties:

**Table 2. Photophysical Properties of Selected Metal Complexes in Dichloromethane Solution**

| **Complex** | **Maximum Emission Wavelength** | **Full Width at Half Maximum** |
|---|---|---|
| Pt46 | 471.8 nm | 45 nm |
| Pt47 | 465.4 nm | 39 nm |
| Pt3 | 471 nm | 37.4 nm |
| Pt49 | 473.8 nm | 50 nm |
| Pt50 | 471 nm | 45.6 nm |
| Pt51 | 469.8 nm | 27.4 nm |
| Pt54 | 469.8 nm | 46 nm |
| Pt171 | 487 nm | 44.8 nm |

**Table 3. Photophysical Properties of Selected Metal Complexes in Dichloromethane Solution at 77 K**

| **Complex** | **Maximum Emission Wavelength** | **Full Width at Half Maximum** |
|---|---|---|
| Pt46 | 461 nm | 35 nm |
| Pt47 | 459 nm | 16 nm |
| Pt3 | 463 nm | 17 nm |
| Pt49 | 480 nm | 21 nm |
| Pt50 | 490 nm | 63 nm |
| Pt51 | 461 nm | 18 nm |
| Pt52 | 463 nm | 41 nm |
| Pt54 | 459 nm | 18 nm |
| Pt171 | 470 nm | 18 nm |

It can be seen from Tables 2 and 3 that, the materials provided by the present disclosure exhibit, in dichloromethane solution, emission wavelengths ranging from 465 nm to 487 nm at room temperature and from 459 to 490 nm at 77 K in their emission spectrum, achieving emission of light ranging from deep blue light to blue light.

### Fabrication of OLED Devices:

A reference fabrication method for device examples in the present disclosure includes the following steps: on a surface of an indium-tin-oxide (ITO) glass substrate with a light-emitting area of 2 mm×2 mm or on an anode, vapor-depositing a p-type doped material or co-depositing a p-type doped material at a mass concentration of 1% to 50% with a hole injection material to form a hole injection layer (HIL) with a thickness of 5 nm to 100 nm; forming a hole transport layer (HTL) with a thickness of 5 nm to 200 nm; forming a light-emitting layer (EML) (which may contain the compound described in the present disclosure) with a thickness of 10 nm 100 nm on the HTL; and forming an electron transport layer (ETL) with a thickness of 20 nm to 200 nm and a cathode with a thickness of 50 nm 200 nm. If necessary, an electron blocking layer (EBL) is introduced between the HTL and the EML, and an electron injection layer (EIL) is introduced between the ETL and the cathode. Thus, an OLED device is fabricated. OLED devices are tested by using standard methods. Unless otherwise specified, the materials for fabricating the devices in the present disclosure can be obtained through known synthesis methods.

In a preferred embodiment, a structure of Device Example 1 provided in the present disclosure is as follows: ITO/P-4 (10 nm)/NPD (60 nm)/HTH-85 (5 nm)/platinum(II) complex: HTH-85:ETH-45 (25 nm) (Pt51:HTH-85:ETH-45 (mass ratio) being 10:60:30)/ETH-5 (5 nm)/ET-14 (40 nm)/Lithium 8-hydroxyquinolinate (LiQ) (1 nm)/Al (100 nm).

Devices in Device Examples 2 to 23 and Comparative Example 1 are fabricated by using structures similar to that of the device in Device Example 1, differing only in that Pt51 in Device Example 1 is substituted with Pt52, Pt46, Pt47, Pt48, Pt49, Pt50, Pt171, Pt53, Pt54, Pt3, Pt6, Pt20, Pt41, Pt71, Pt72, Pt76, Pt80, Pt81, Pt102, Pt111, Pt174 and Pt183 in Device Examples 2 to 23, respectively, and with R1 in Comparative Example 1. The light-emitting characteristics of the fabricated devices in comparative example and the device examples are tested by using standard methods; and the data are presented in Table 4. Structural formulas of the involved compounds are as follows, P-4 denoting HATCN, ET-14 denoting BPyTP.

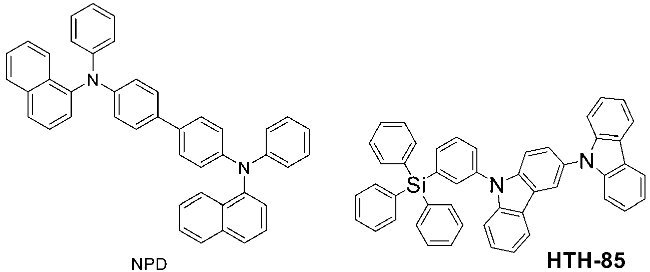

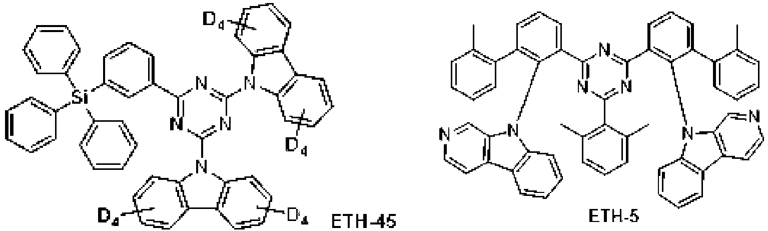

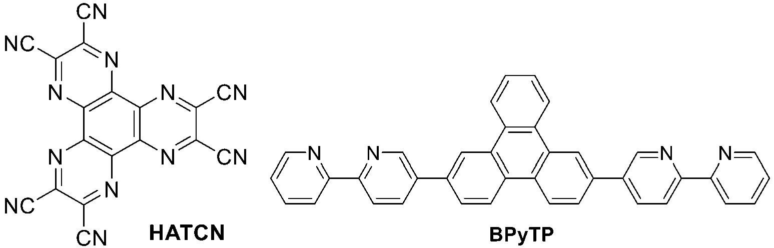

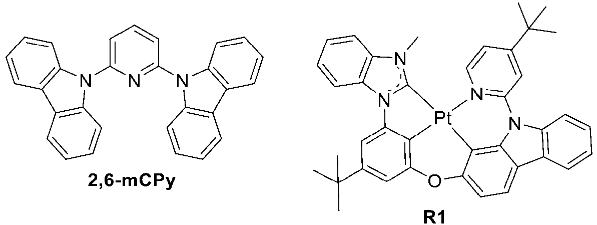

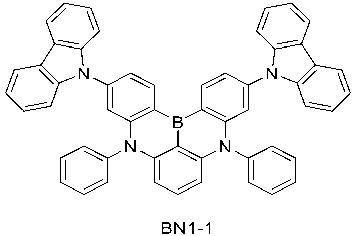

**Table 4. Device Luminescence Characteristics Data Sheet**

| Example | Light-Emitting Layer | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example | R1 | 100 | 100 | 100 |
| Device Example 1 | Pt51 | 96 | 132 | 151 |
| Device Example 2 | Pt52 | 96 | 133 | 150 |
| Device Example 3 | Pt46 | 97 | 131 | 155 |
| Device Example 4 | Pt47 | 95 | 137 | 159 |
| Device Example 5 | Pt48 | 96 | 135 | 158 |
| Device Example 6 | Pt49 | 97 | 132 | 165 |
| Device Example 7 | Pt50 | 95 | 132 | 136 |
| Device Example 8 | Pt171 | 95 | 136 | 138 |
| Device Example 9 | Pt53 | 96 | 131 | 153 |
| Device Example 10 | Pt54 | 97 | 140 | 162 |
| Device Example 11 | Pt3 | 97 | 128 | 130 |
| Device Example 12 | Pt6 | 97 | 131 | 146 |
| Device Example 13 | Pt20 | 97 | 130 | 139 |
| Device Example 14 | Pt41 | 96 | 128 | 150 |
| Device Example 15 | Pt71 | 97 | 133 | 144 |
| Device Example 16 | Pt72 | 96 | 129 | 152 |
| Device Example 17 | Pt76 | 96 | 141 | 157 |
| Device Example 18 | Pt80 | 97 | 132 | 151 |
| Device Example 19 | Pt81 | 97 | 135 | 139 |
| Device Example 20 | Pt102 | 97 | 130 | 145 |
| Device Example 21 | Pt111 | 98 | 131 | 143 |
| Device Example 22 | Pt174 | 97 | 135 | 154 |
| Device Example 23 | Pt183 | 97 | 135 | 149 |

As shown in Table 4, compared with Comparative Example 1, Device Examples 1 to 23 fabricated in the present disclosure demonstrate superior device performance in terms of drive voltage, current efficiency and device lifetime. The performance improvements of the device examples are based on the superior electron transport capabilities of the specific compound materials provided in the present disclosure. It can be seen that, when the compound materials of the present disclosure are each used as a material of a light-emitting layer of an electronic device, a drive voltage may be reduced, and current efficiency and device lifetime may also be improved. In addition, the devices fabricated in the present disclosure are all deep blue light-emitting devices, with CIEy values all below 0.19. This indicates that the compounds provided in the present disclosure possess certain commercial application value.

In a preferred embodiment of the present disclosure, a structure of Device Example 24 is as follows: ITO/P-4 (10 nm)/NPD (60 nm)/HTH-85 (5 nm)/platinum(II) complex: boron-containing compounds:HTH-85:ETH-45 (25 nm) (Pt51:BN1-8:HTH-85:ETH-45 (mass ratio) being 10:1:59:30)/ETH-5 (5 nm)/ET-14 (40 nm)/LiQ (1 nm)/Al (100 nm).

Device Examples 25 to 30 are fabricated by using a structure similar to that of Device Example 24, differing only in that respectively using compounds listed in Table 5 to replace the platinum(II) complex and the boron-containing compound in Device Example 24. The device structure and luminescence characteristics data is shown in Table 5.

**Table 5. Device Structure and Luminescence Characteristics Data Sheet**

| Example | Platinum(II) Complex: Boron- Containing Compound | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example | R1 | 100 | 100 | 100 |
| Device Example 24 | Pt51:BN1-1 | 96 | 135 | 149 |
| Device Example 25 | Pt49:BN1-1 | 97 | 138 | 157 |
| Device Example 26 | Pt54:BN1-1 | 95 | 135 | 143 |
| Device Example 27 | Pt41:BN1-1 | 97 | 137 | 143 |
| Device Example 28 | Pt72:BN1-1 | 97 | 126 | 150 |
| Device Example 29 | Pt102:BN1-1 | 98 | 129 | 140 |
| Device Example 30 | Pt171:BN1-1 | 96 | 133 | 135 |

It can be seen from Table 5 that, when the compounds of the present disclosure, which are used as sensitizing materials, and the boron-containing compounds are co-used as light-emitting materials in devices, the performances of the devices are also significantly enhanced. This further indicates that the compounds provided in the present disclosure possess certain commercial application value. In addition, a sensitized device structure that incorporates a boron-containing compound may further reduce a CIEy value, thereby further improving a color purity of emitted light of a device.

The applicant declares that the foregoing description constitutes only specific embodiments of the present disclosure, but the scope of protection of the present disclosure is not limited thereto. Those skilled in the art shall understand that any modifications or substitutions readily conceivable to a person skilled in the art within the technical scope disclosed by the present disclosure fall within the scope of protection and disclosure of the present disclosure.

## Claims

1. A pyridine-fused carbene-based tetradentate cyclometalated platinum(II) complex, **characterized by** having a general structure shown in formula (I): 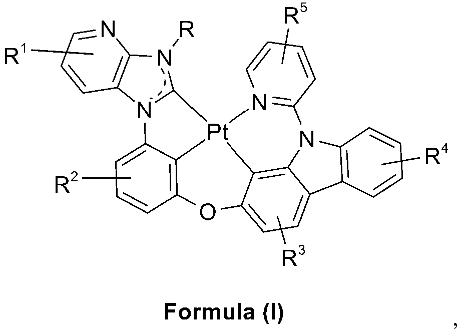 wherein in formula (I), R¹-R⁵ each independently represent from mono to maximum allowable substitution, or no substitution; R¹-R⁵ are each independently selected from the group consisting of: hydrogen, deuterium (D), C1-C30 alkyl, C1-C30 deuterated alkyl, C6-C60 aryl, C6-C30 aryl silane, and combinations thereof; and R is selected from the group consisting of hydrogen, deuterium, C1-C30 alkyl, C1-C30 cycloalkyl, C1-C30 deuterated alkyl, C6-C60 aryl, C6-C30 fused-ring aryl, and combinations thereof.

2. The tetradentate cyclometalated platinum(II) complex according to claim 1, **characterized in that**, R¹-R⁵ are each independently selected from hydrogen, deuterium, methyl, ethyl, n-propyl, isopropyl, n-butyl, isobutyl, sec-butyl, tert-butyl, n-pentyl, isopentyl, sec-pentyl, tert-pentyl, n-hexyl, isohexyl, sec-hexyl, tert-hexyl, n-heptyl, isoheptyl, sec-heptyl, tert-heptyl, n-octyl, iso-octyl, sec-octyl, tert-octyl, n-nonyl, iso-nonyl, sec-nonyl, tert-nonyl, n-decyl, isodecyl, sec-decyl, tert-decyl, phenyl, triphenylsilane, and combinations thereof.

3. The tetradentate cyclometalated platinum(II) complex according to claim 1, **characterized in that**, R is selected from amantadine, tert-butyl, tert-butylphenyl, and groups represented by following structural formulas: 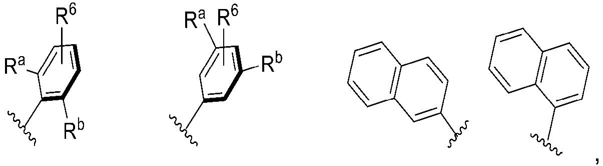 wherein R⁶ represents from mono to maximum number allowable substitution, or no substitution; R⁶ is selected from hydrogen, C1-C20 alkyl and C1-C20 deuterated alkyl; and R^{a} and R^{b} are identically or independently selected from C3-C30 alkyl, C1-C20 deuterated alkyl, C5-C30 cycloalkyl, C6-C30 aryl, and combinations thereof.

4. The tetradentate cyclometalated platinum(II) complex according to claim 3, **characterized in that**, R⁶ is selected from hydrogen, methyl, n-propyl, isopropyl, n-butyl, isobutyl, sec-butyl, tert-butyl, D and CD₃; and R^{a} and R^{b} are identically or independently selected from methyl, ethyl, n-propyl, isopropyl, n-butyl, isobutyl, sec-butyl, tert-butyl, n-pentyl, isopentyl, sec-pentyl, tert-pentyl, n-hexyl, iso-hexyl, sec-hexyl, tert-hexyl, phenyl, and combinations thereof.

5. The tetradentate cyclometalated platinum(II) complex according to any one of claims **1** to **4**, **characterized in that**, the pyridine-fused carbene-based tetradentate cyclometalated platinum(II) complex is any one selected from chemical structures shown below, wherein D represents deuterium, and Ph represents phenyl:

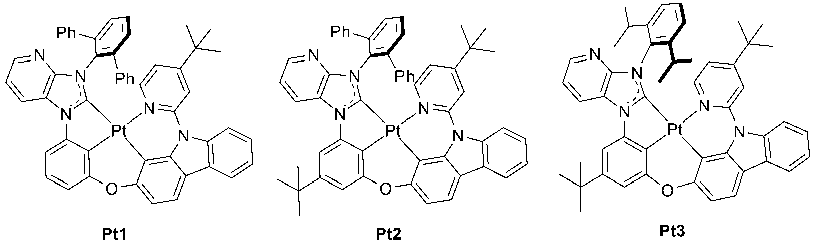

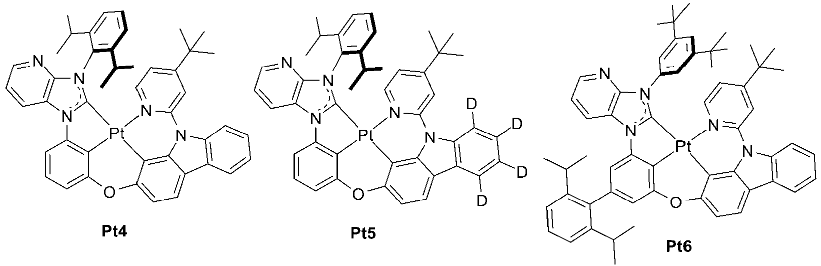

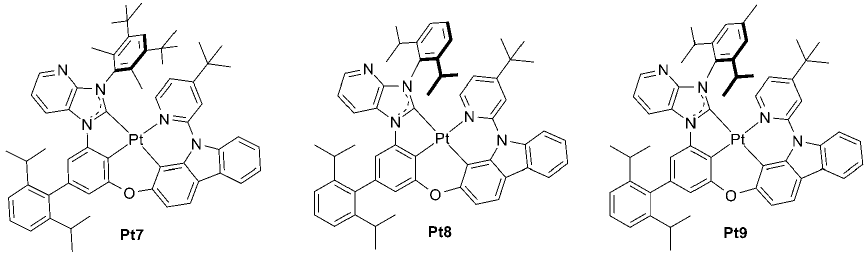

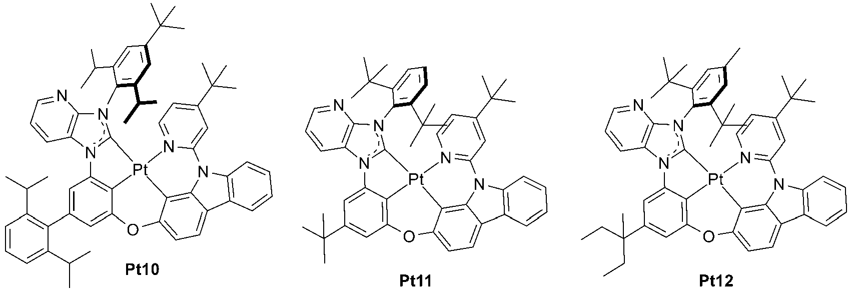

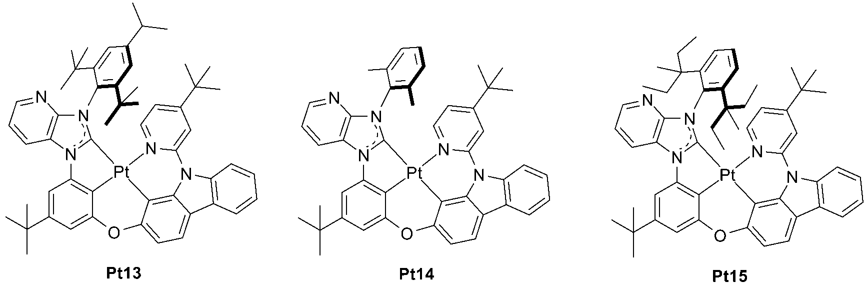

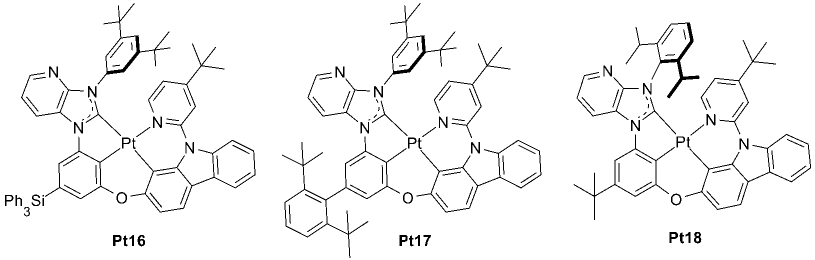

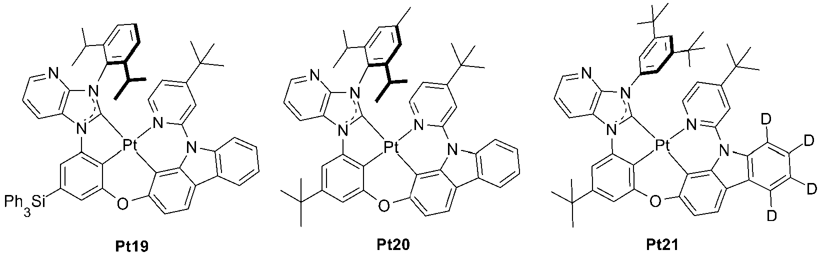

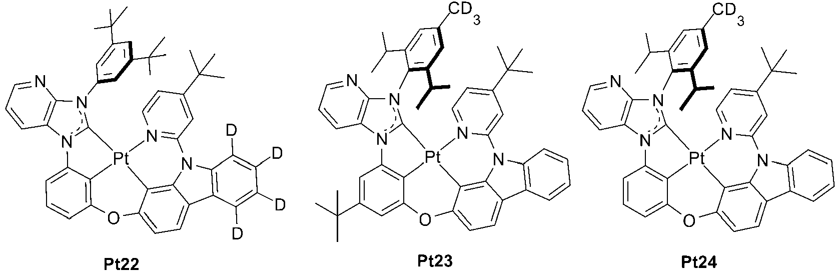

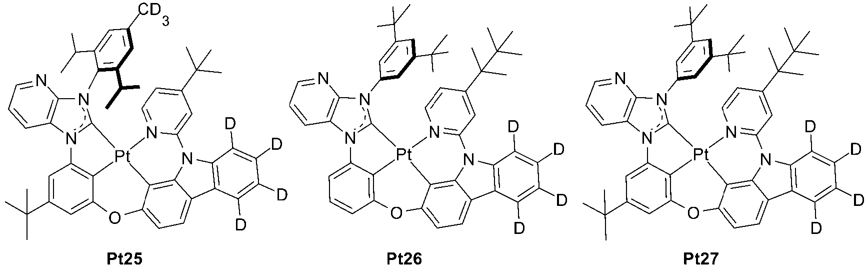

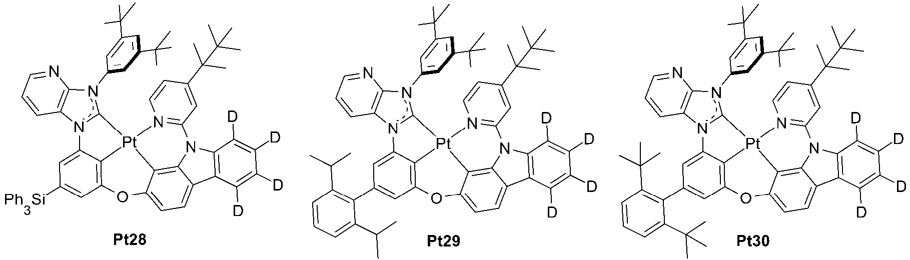

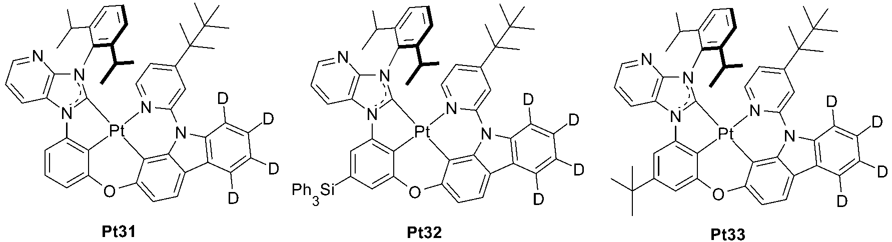

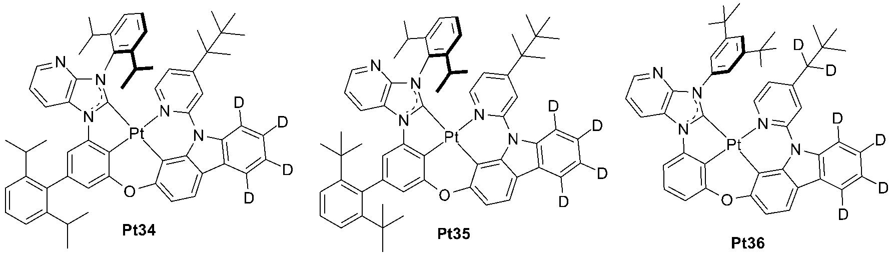

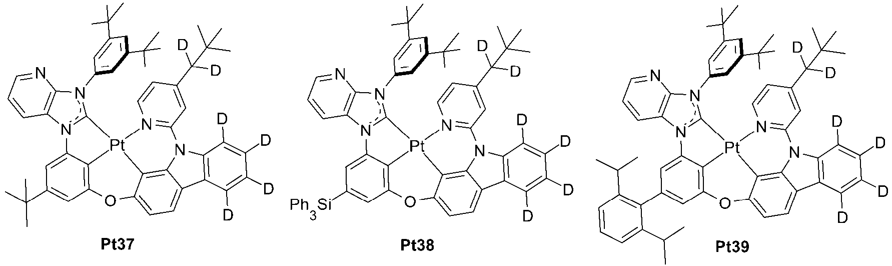

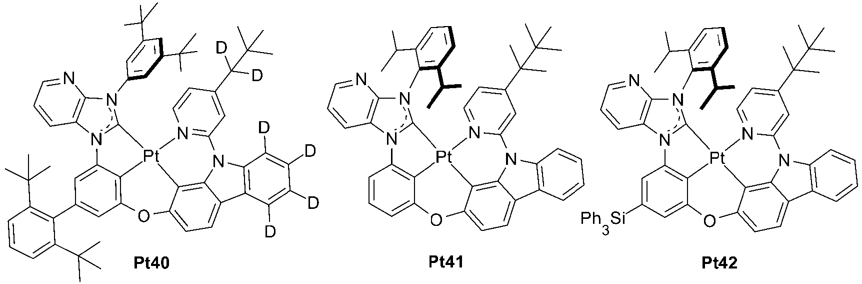

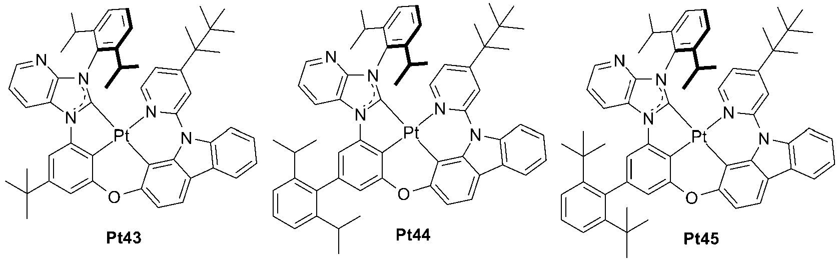

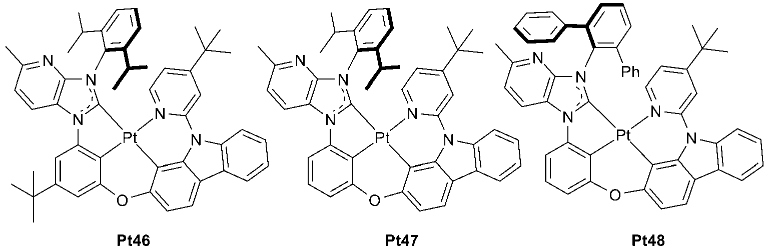

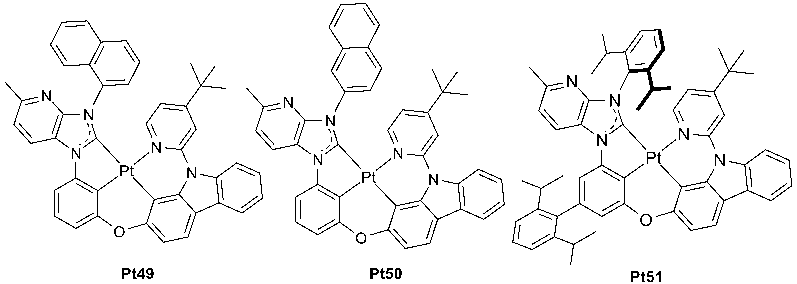

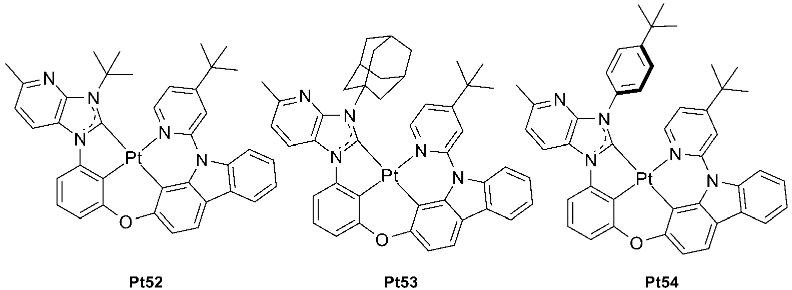

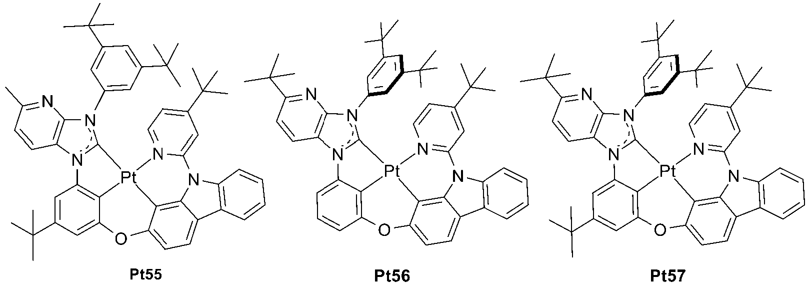

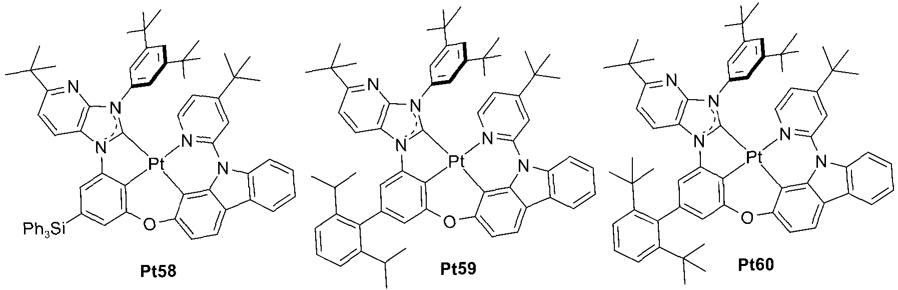

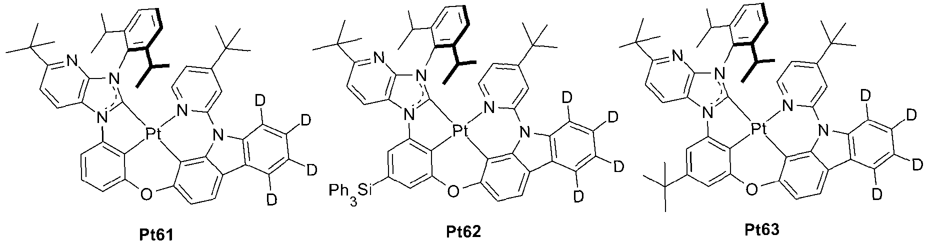

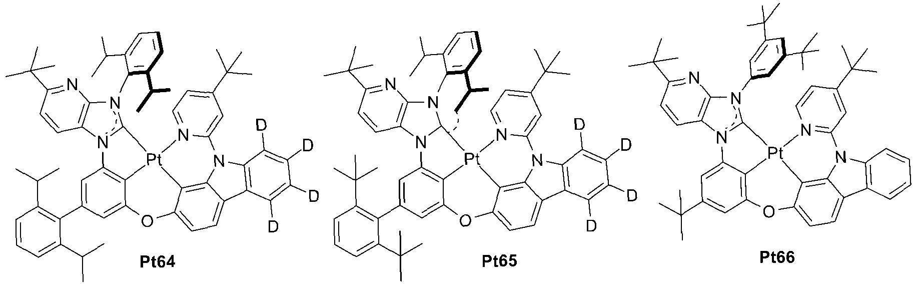

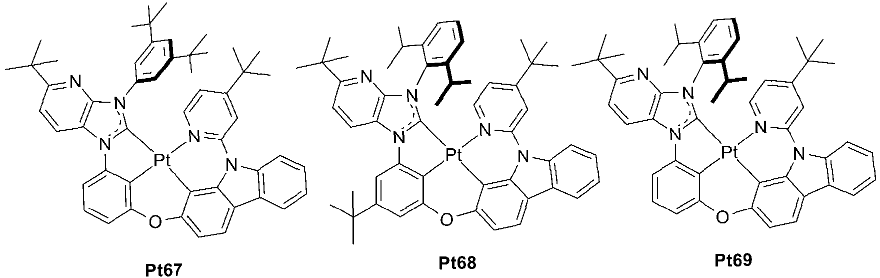

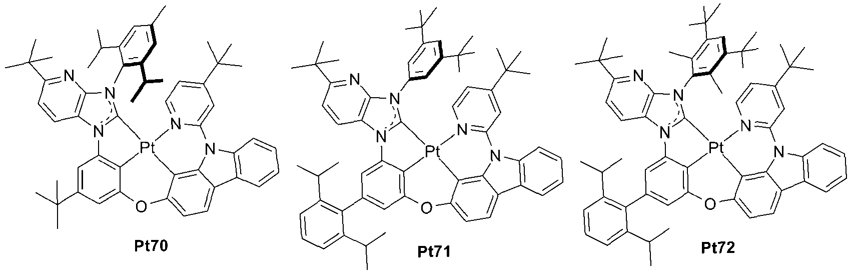

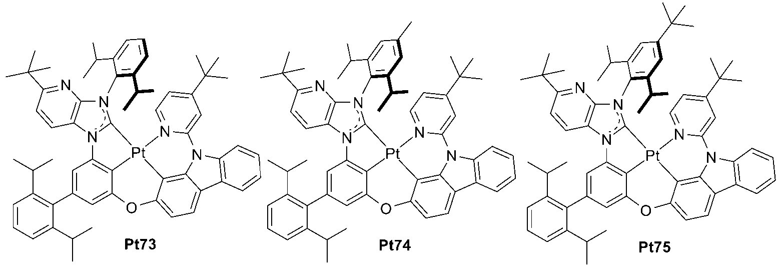

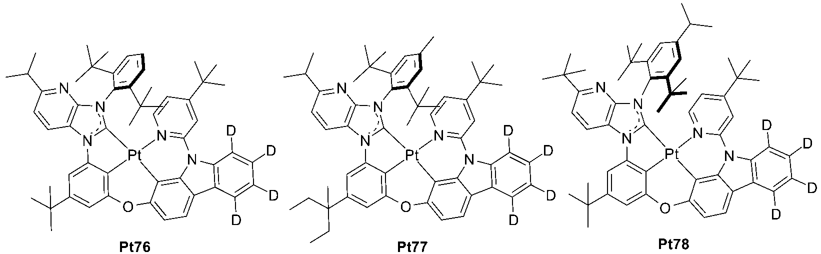

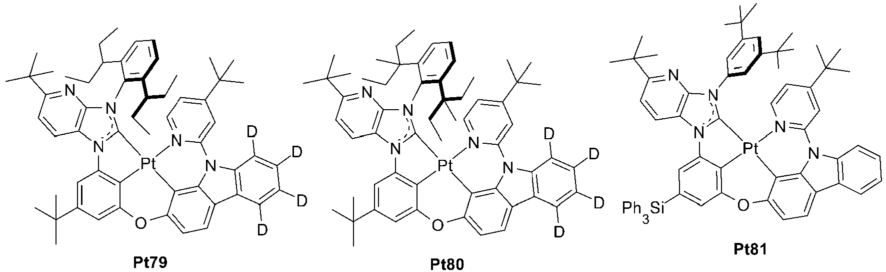

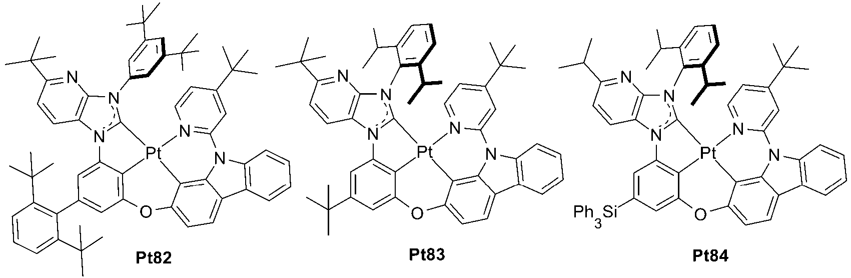

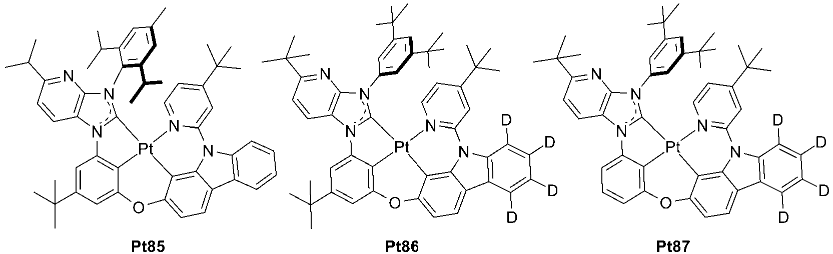

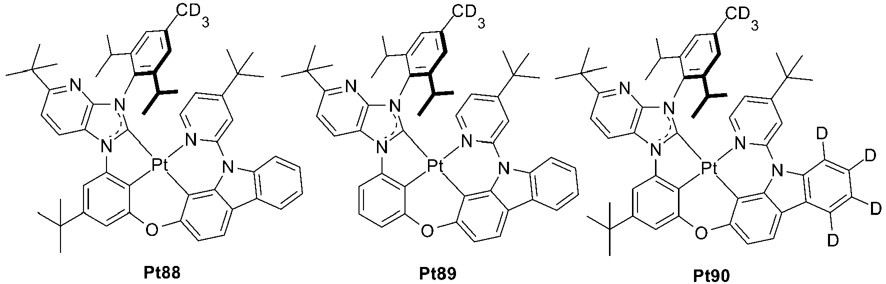

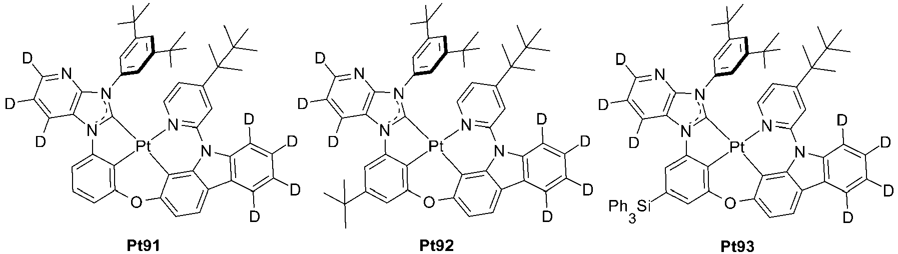

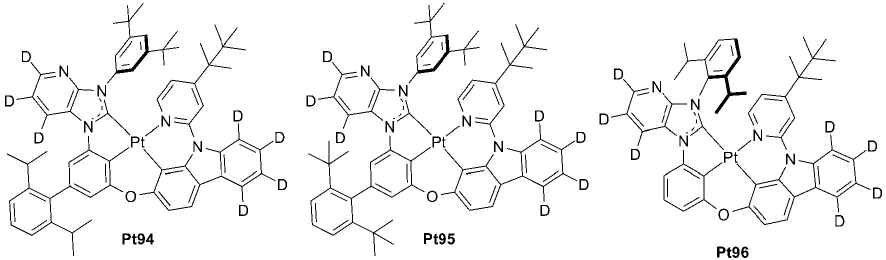

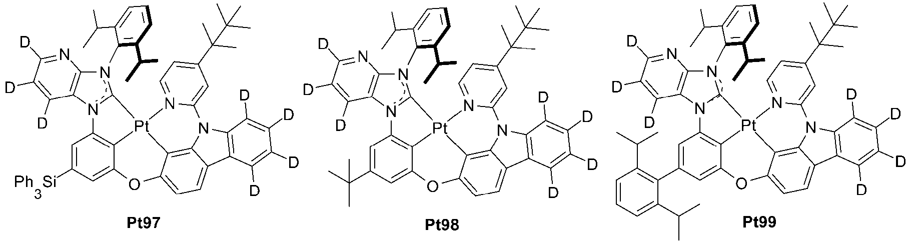

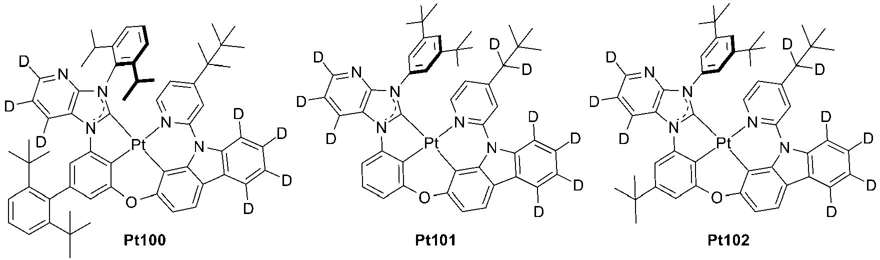

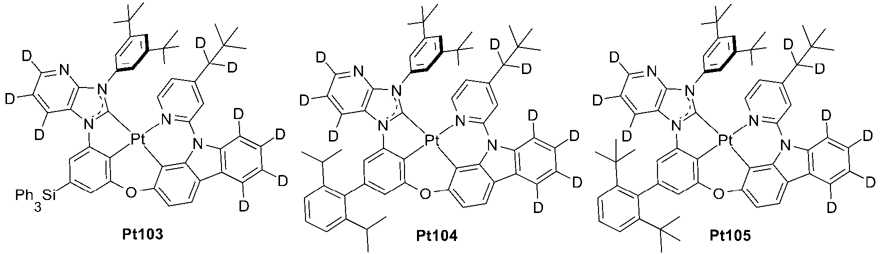

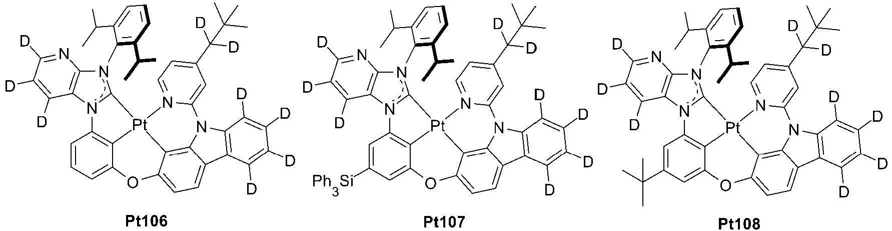

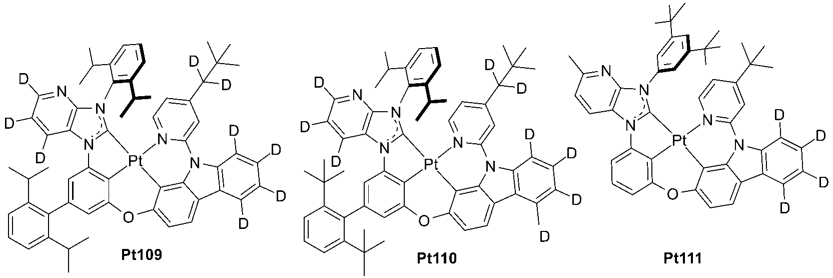

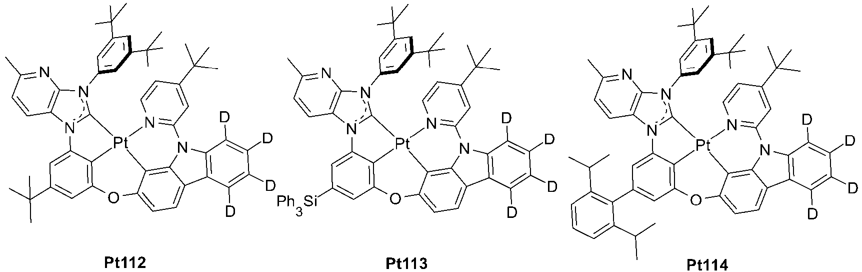

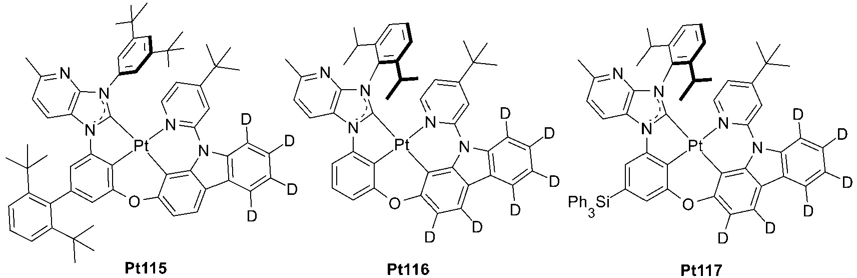

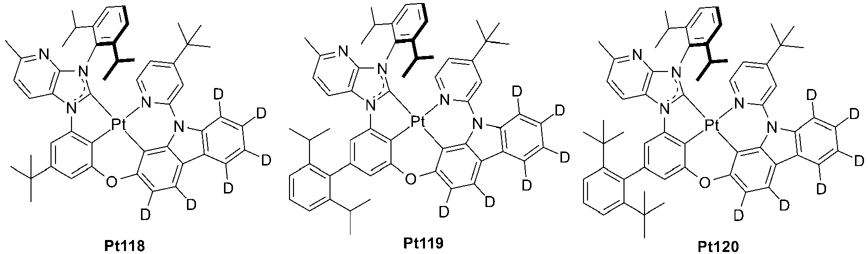

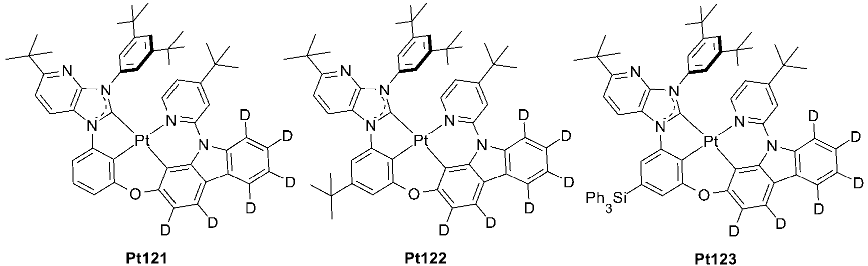

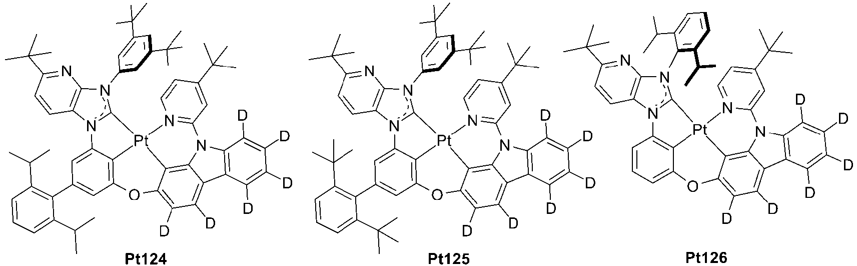

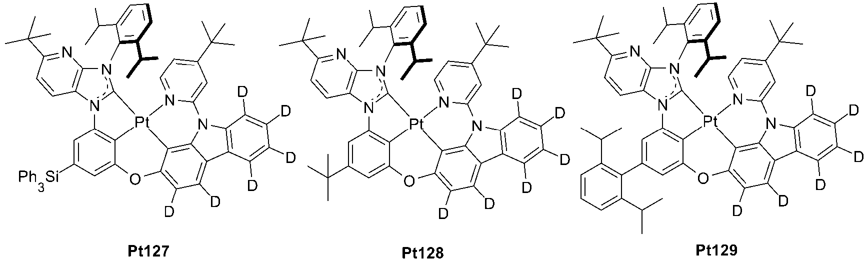

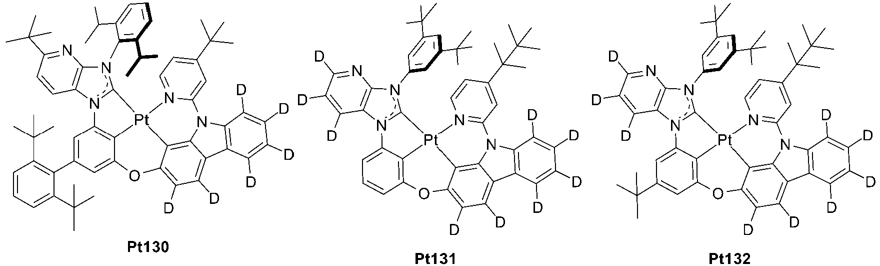

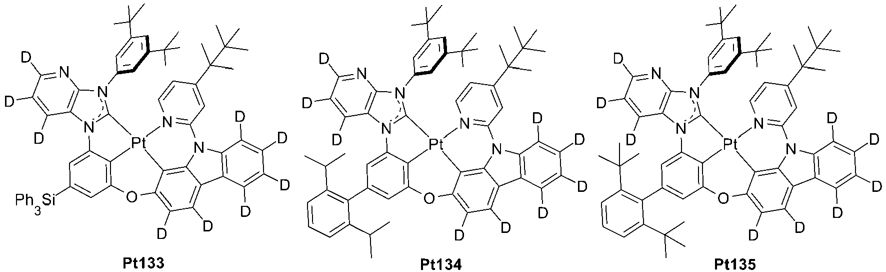

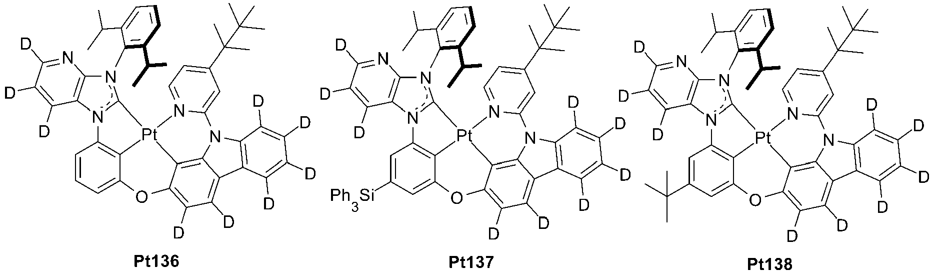

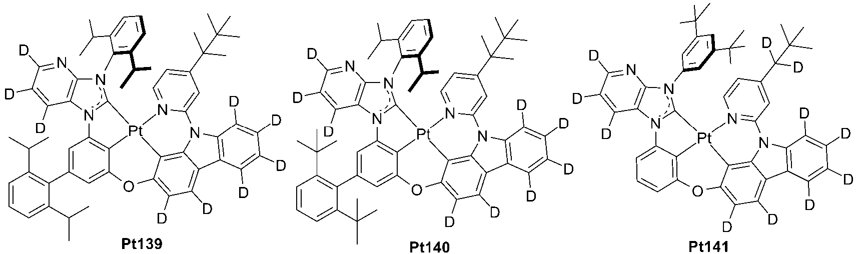

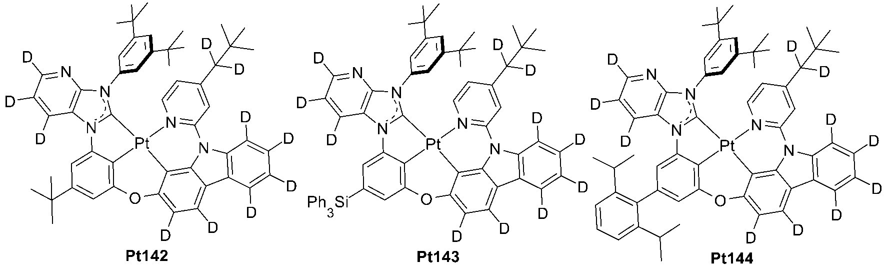

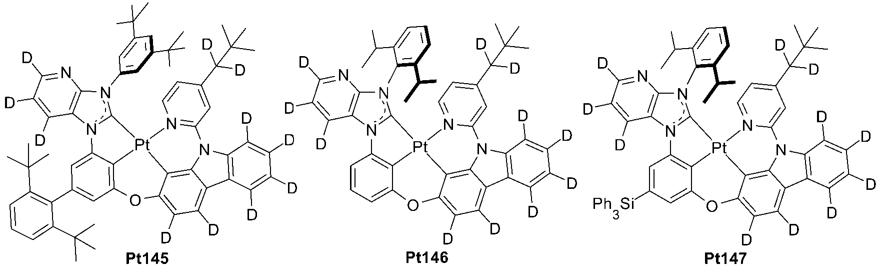

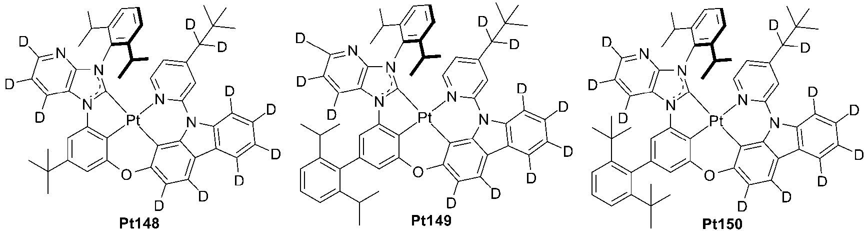

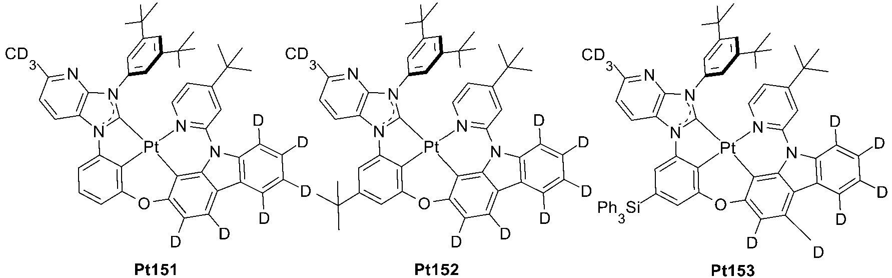

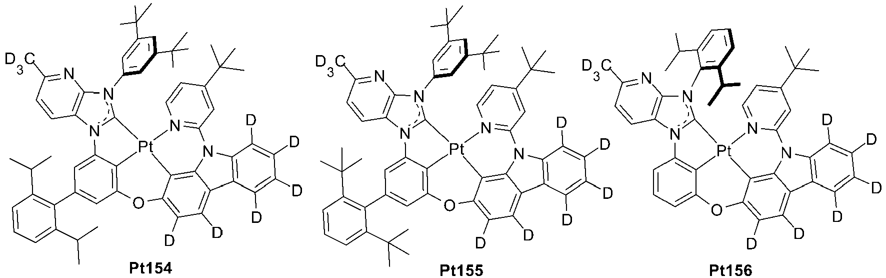

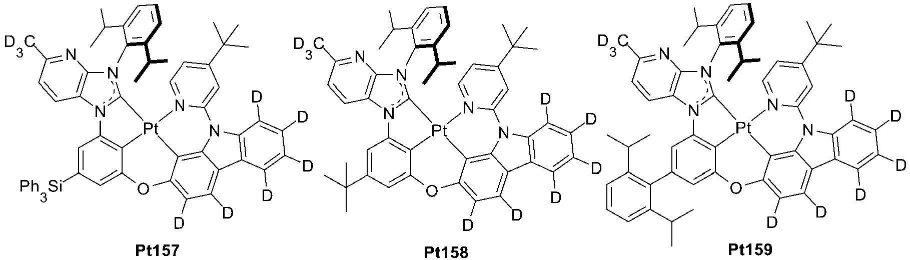

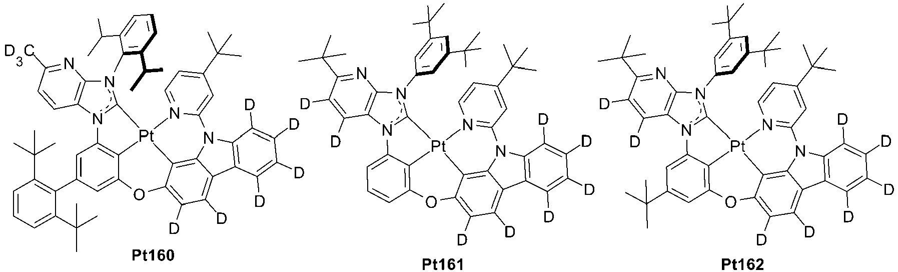

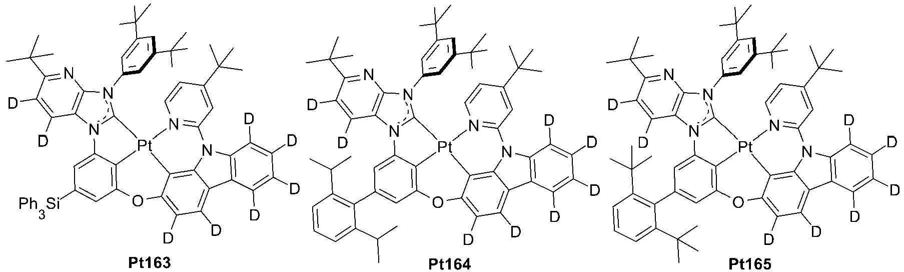

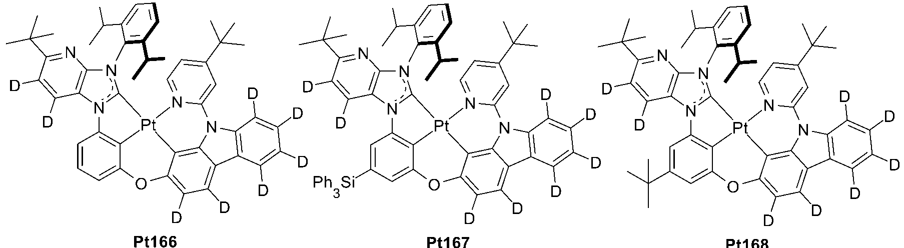

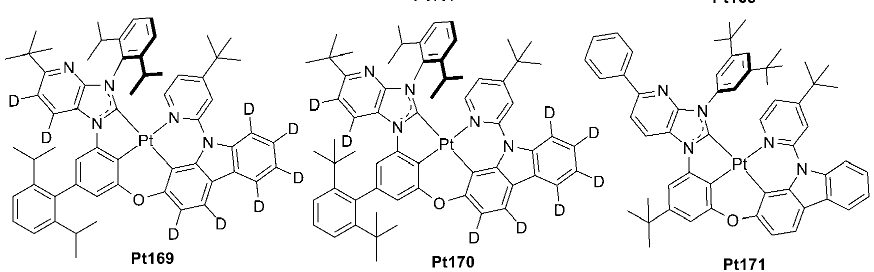

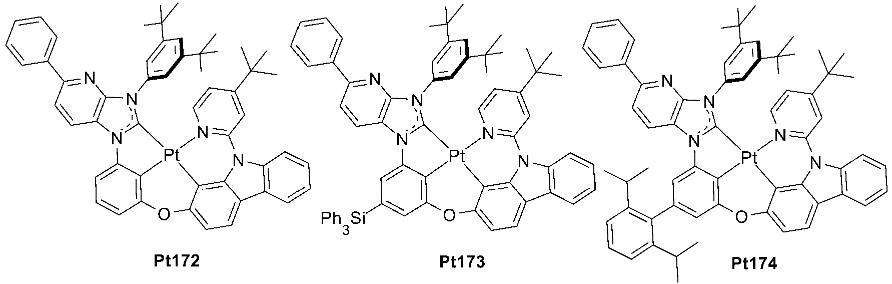

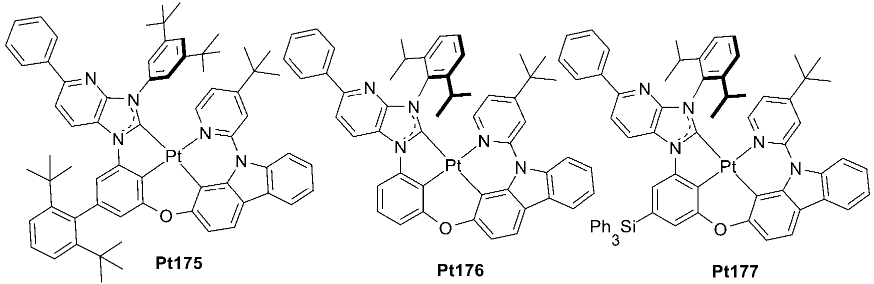

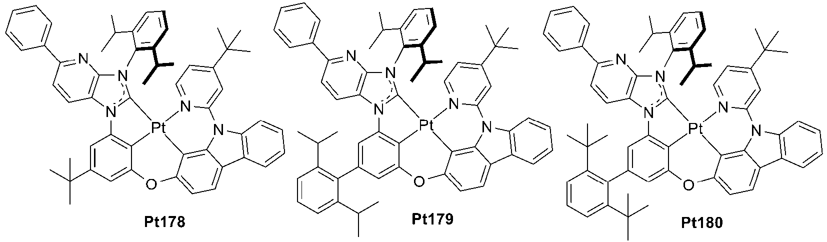

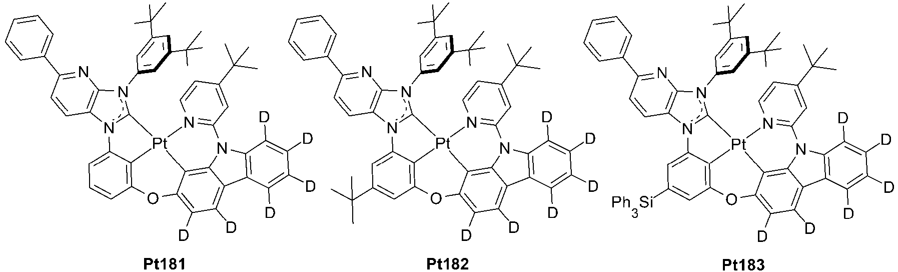

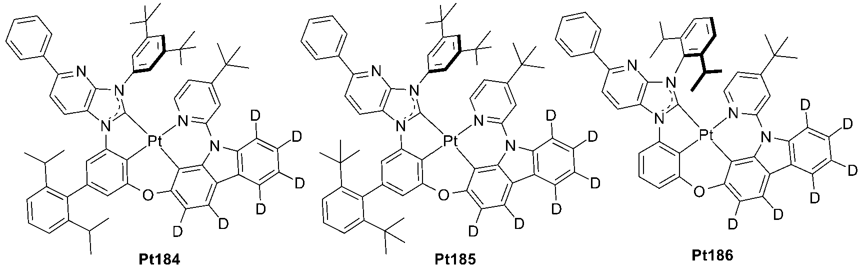

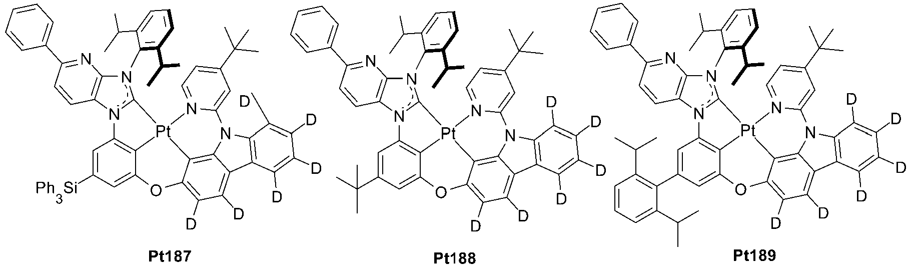

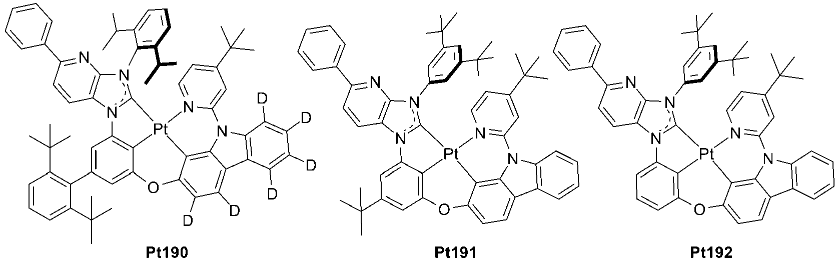

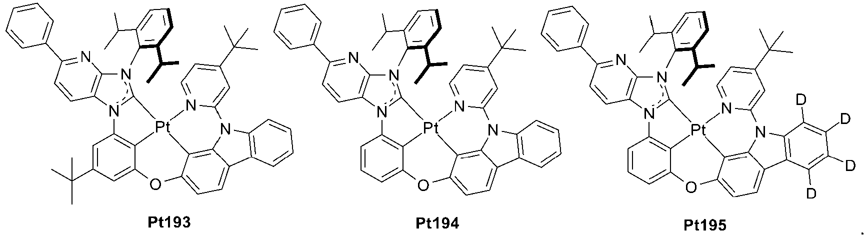

6. An application of the tetradentate cyclometalated platinum(II) complex according to any one of claims **1** to **5** in an electronic device, wherein the electronic device comprises one or more of an organic electroluminescent device, an organic integrated circuit, an organic field-effect transistor, an organic thin-film transistor, an organic light-emitting transistor, an organic solar cell, an organic optical detector, an organophotoreceptor, an organic field-quench device, a light-emitting electrochemical cell and an organic laser diode.

7. An organic electroluminescent device, **characterized in that**, the organic electroluminescent device comprises a cathode, an anode and an organic functional layer between the cathode and the anode, wherein the organic functional layer contains the tetradentate cyclometalated platinum(II) complex according to any one of claims **1** to **5.**

8. An organic electroluminescent device, **characterized in that**, the organic functional layer includes a light-emitting layer, wherein the light-emitting layer contains the tetradentate cyclometalated platinum(II) complex according to any one of claims **1** to **5.**

9. The organic electroluminescent device according to claim **7, characterized in that**, the light-emitting layer further includes a fluorescent dopant material, wherein the fluorescent dopant material is a boron-containing compound.

10. An organic optoelectronic device, **characterized in that**, the organic optoelectronic device comprises: a substrate layer, a first electrode disposed on the substrate, an organic light-emitting functional layer disposed on the first electrode, and a second electrode disposed on the organic light-emitting functional layer, wherein the organic light-emitting functional layer contains the tetradentate cyclometalated platinum(II) complex according to any one of claims **1 to 5.**

11. The organic optoelectronic device according to claim **10**, **characterized in that**, the organic light-emitting functional layer further contains a fluorescent dopant material, wherein the fluorescent dopant material is a boron-containing organic molecular light-emitting material.

12. A composition, **characterized in that**, the composition contains the tetradentate platinum(II) complex according to any one of claims **1** to **5.**

13. A formulation, **characterized in that**, the formulation contains the tetradentate platinum(II) complex according to any one of claims **1** to **5.**

14. A display or lighting apparatus, **characterized in that**, the apparatus comprises at least one organic electroluminescent device each according to any one of claims **7** to **9.**
